(19) Europäisches Patentamt
European Patent Office
Office européen des brevets

(11) EP 1 757 981 B1

(12) **EUROPEAN PATENT SPECIFICATION**

(45) Date of publication and mention of the grant of the patent:
**14.10.2009 Bulletin 2009/42**

(51) Int Cl.:
***G03F 7/033*** (2006.01) ***B41C 1/10*** (2006.01)

(21) Application number: **05107827.7**

(22) Date of filing: **26.08.2005**

(54) **Photopolymer printing plate precursor**

photopolymer Druckplattenvorläufer

Précurseur de plaque d’impression photopolymère

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**28.02.2007 Bulletin 2007/09**

(73) Proprietor: **Agfa Graphics N.V.**
**2640 Mortsel (BE)**

(72) Inventors:
- **Williamson, Alexander,**
**2640 Mortsel (BE)**
- **Van Damme, Marc,**
**2640 Mortsel (BE)**
- **Jaunky, Wojciech**
**2640 Mortsel (BE)**
- **Van Aert, Hubertus**
**2640 Mortsel (BE)**

(74) Representative: **Goedeweeck, Rudi et al**
**Agfa Graphics N.V.**
**IP Department 3622**
**Septestraat 27**
**2640 Mortsel (BE)**

(56) References cited:
**EP-A- 1 070 990** **EP-A- 1 349 006**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 757 981 B1

## Description

FIELD OF THE INVENTION

The present invention relates to a photopolymer printing plate precursor comprising a photosensitive coating on a support, wherein said photosensitive coating comprises a composition that is photopolymerizable upon absorption of light, said composition comprising a binder, a polymerizable compound, a sensitizer and a photoinitiator.
The invention also relates to a method of making a lithographic printing plate therewith.

BACKGROUND OF THE INVENTION

In lithographic printing, a so-called printing master such as a printing plate is mounted on a cylinder of the printing press. The master carries a lithographic image on its surface and a printed copy is obtained by applying ink to said image and then transferring the ink from the master onto a receiver material, which is typically paper. In conventional, so-called "wet" lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called "driographic" printing, the lithographic image consists of ink-accepting and ink-abhesive (ink-repelling) areas and during driographic printing, only ink is supplied to the master. The lithographic image usually is made by exposing an image to a photopolymerizable composition coated on a support and developing said image. Such photopolymerizable compositions are well known in the art and are not only used for printing plate precursors, but also e.g. as photoresists for printed electronic circuits.
Said photosensitive compositions usually comprise a polymeric binder, an unsaturated polymerizable compound and a photoinitiator and often are of low sensitivity, so that exposure has to be done by continuous high intensity lamps for seconds up to minutes.
As an example such photopolymerizable compositions of low sensitivity are known from DE 2 064 080 OS, wherein the binder polymer comprises specific methacrylic acid / long chain alkyl methacrylic acid ester copolymers, that preferably have an acid number from 100 to 250. Such compositions are disclosed to enhance adhesion to metal supports of any kind, in particular to copper surfaces, and hardened layers comprising such copolymers are described to have a good resistence against developers.
The photosensitive resin composition according to EP 398 325 A comprises as a binder a mixture of a hydrophobic polymer and a hydrophilic polymer, wherein the hydrophilic polymer comprises hydrophilic groups like carboxy groups and the hydrophobic polymer preferably comprises chlorine substituents and has a glass transition temperature (Tg) not higher than 5 °C. Said compositions are disclosed to be useful for the production of flexographic printing plates with good ink resistance.
According to US 4,780,393 and US 4,940,647 the photopolymerizable compositions disclosed therein comprising a polymeric binder, a polymerizable compound, a photoinitiator and a leuco dye, have advantages e.g. in sensitivity and contrast. In Example 1 are demonstrated in every case dry resist films and exposure is done by means of an iron doped 5 kW halide lampe at short distance.
A photopolymerizable composition comprising a specific photoinitiator system and optionally a polymeric binder is disclosed in GB 1 576 217 to have good light-sensitivity in combination with a high cross-linking density. According to the examples exposure has to be done with high-energy lamps, e.g. a 8 kW "Xenokop" spot arc lamp, for a coated copper circuit plate.
Photosensitive compositions with binder copolymers comprising specific polymeric block units are known e.g. from EP 718 695 A to result in a granular copolymer; from US 5 348 844, wherein a linear block copolymer of specific composition is mixed with a latex copolymer to give a water developable composition; from US 5,212,049 in combination with a specific polymerizable compound; from EP 480 335 A to result in amphiphilic elastomeric binders; from US 4 248 960, wherein the copolymer is placed in a separate lamina; from US 6 326 126 for specific tercopolymer binders; from US 6 017 678 for binder polymers with at least 4 different blocks; and from US 6 780 566 from compositions comprising a mixture of specific copolymers.
Printing masters can e.g. be obtained by the so-called computer-to-film (CtF) method, wherein various prepress steps such as typeface selection, scanning, color separation, screening, trapping, layout and imposition are accomplished digitally and each color selection is transferred to graphic arts film using an imagesetter. After processing, the film can be used as a mask for the exposure of an imaging material called plate precursor and after plate processing, a printing plate is obtained which can be used as a master.
Since about 1995, the so-called 'computer-to-plate' (CtP) method has gained a lot of interest. This method, also called 'direct-to-plate', bypasses the creation of film because the digital document is transferred directly to a printing plate precursor by means of a so-called plate-setter. A printing plate precursor for CtP is often called a digital plate.
To allow the direct output of digital images to printing plate precursors, there have been developed photopolymerizable compositions that are sensitive enough to be directly exposed with a laser beam and therefore short pixel times. As pixel time is meant in the context of the present invention the effective time each part of the printing plate is exposed by the scanning laser beam.

Digital plates can roughly be divided in three categories : (i) silver plates, which work according to the silver salt diffusion transfer mechanism; (ii) UV/VIS photopolymer plates which contain a photopolymerizable composition that hardens upon exposure to light and (iii) thermal (including IR photopolymer, Novolak and latex-based) plates of which the imaging mechanism is triggered by heat or by light-to-heat conversion. Thermal plates are mainly sensitized for infrared lasers emitting at 830 nm or 1064 nm. Typical photopolymer plates are sensitized for visible light, mainly for exposure by an Ar laser (488 nm) or a FD-YAG laser (532 nm). The wide-scale availability of low cost blue or violet laser diodes, originally developed for data storage by means of DVD, has enabled the production of plate-setters operating at shorter wavelength. More specifically, semiconductor lasers emitting from 350 to 450 nm have been realized using an InGaN material.

From EP 1 403 043 are known IR sensitive layers comprising a polyacrylic acid ester or polyacrylic acid amide binder having at least one free carboxylic acid group in each repeating unit. The binder is disclosed to be a homopolymer or a copolymer and preferably has a Tg from 70 to 300 °C. Similar binders are also disclosed in EP 1 403 042, EP 1 403 041 and EP 1 176 467.

From EP 1 349 006 are known photopolymerizable compositions with high sensitivity for UV, violet and blue light, that comprise specific sensitizers, and wherein the binder used in the examples is a methacrylate/methacrylic acid copolymer having a Tg of over 100 °C.

In known photopolymer plates, in particular in plates of high sensitivity, it has been observed, that the process of polymerization during exposure often comes to an end, before all of the exposed areas have enough resistance to not be dissolved by an aqueous developer. It has been found, that this point, where little or no further polymerisation occurs, can be overcome by a so called pre-heat step. The pre-heat step usually is done directly after light exposure, in particular when using visible or UV lasers, and typically consists of heating the printing plate precursor for 10 seconds to 1 minute to temperatures in the range of 90 °C to 150 °C to promote polymerization before the development step. This step is unfavourable as it requires special equipment and extra time for the manufacturing process. In addition the pre-heat step may cause artefacts in the printed image like so called asteroids that can be avoided by the present invention.

## SUMMARY OF THE INVENTION

It is an object of the present invention to provide a photopolymer printing plate precursor that can be exposed by a low intensity laser, and that has sufficient resistence of the imagewise hardened composition, even if no pre-heat step is done between exposure and development, and that can be processed by alkaline developers without loosing parts of the image.

Surprisingly the object of the present invention can be achieved by a photopolymer printing plate precursor with a photopolymerizable composition comprising at least one binder, a polymerizable compound, a sensitizer and a photoinitiator, wherein said binder is a copolymer that has a Tg of less than 70 °C and wherein 1 to 50 mol-% of the monomeric units of said copolymer contain at least one acidic group. The printing plate precursor of the present invention is a flexographic or lithographic printing plate precursor, the latter being highly preferred.

In particular the object of the present invention can be achieved by a method of making a lithographic printing plate comprising the steps of providing a photopolymer printing plate precursor as defined in any of the preceding claims, exposing said printing plate precursor with a laser and processing the printing plate precursor in an aqueous alkaline developer.

Preferred embodiments of the printing plate precursor and of the method of making a lithographic printing plate therewith are defined in the dependent claims.

## DETAILED DESCRIPTION OF THE INVENTION

The present invention relates to a photopolymer printing plate precursor comprising a photosensitive coating on a support, wherein said photosensitive coating comprises a composition that is photopolymerizable upon absorption of light, said composition comprising at least one binder, a polymerizable compound, a sensitizer and a photoinitiator, characterized in that said binder is a copolymer that has a Tg of less than 70 °C and wherein 1 to 50 mol-% of the monomeric units of said copolymer contain at least one acidic group.

The glass transition temperature (Tg) according to the present invention is determined by differential scanning calorimetry (DSC).

Although the photopolymer printing plate precursor of the present invention can also advantageously be used for high-intensity exposure and also when using a pre-heat step, the advantages of the present invention are particularly pronounced for laser exposure with medium to low energy and no pre-heat step, in particular when using UV or visible light.

Not knowing the underlying mechanism, the low Tg binder results in a lower overall Tg for the photolayer, which might allow easier diffusion of the initiating species and the propagating monomers through the photopolymerising matrix, which results in a greater degree of polymerisation without the need to use pre-heat to raise the temperature of the photolayer above the Tg. Possibly, because irradiation with a visible laser produces little heat, the advantage of a low Tg binder may be more pronounced for visible light-sensitive systems than for IR sensitive systems in which heat is produced during irradiation.

In a preferred embodiment of the present invention the photopolymerizable composition is sensitive to wavelengths between 300 and 1200 nm, in particular between 300 and 600 nm, and particularly preferred between 350 and 450 nm. It is preferred, that the photopolymerizable composition has a high sensitivity, in particular that the minimum exposure necessary for image formation, measured on the surface of the plate, is 100 $\mu J/cm^2$ or less.

The binder of the present invention can be selected from a wide series of organic copolymers as presently claimed. The copolymer can be polymerized from two, three, four or more different mixed monomers and preferably contains two or three different monomers. In the context of the present invention different monomers means monomers of different chemical structure. The different monomers can be distributed in the binder copolymer of the present invention in any way, e.g. randomly or as blocks. In a preferred embodiment of the present invention the different monomers are distributed randomly and/or comprise blocks with an average length of less than 20 monomeric units.

The binder of the present invention can also be a composition of different copolymers, as long as the average Tg of the composition is less than 70 °C and 1 to 50 mol-% of the monomeric units in said composition contain at least one acidic group.

The Tg of the binder according to the present invention preferably is less than 60 °C, in particular less than 50 °C and particularly preferred less than 30 °C. However, this value is dependent on the amount of binder used in the photolayer. For example, when a larger amount of binder is used, it becomes more important that the Tg is low, than when a lower amount of binder is used, due to the fact that a small amount of binder will have less influence on the overall Tg of the photolayer than a large amount of binder. The amount of binder(s) generally ranges from 10 to 90 % by weight, preferably 20 to 80 % by weight, relative to the total weight of the non-volatile components of the composition.

In a preferred embodiment of the present invention from 2 to 30 mol-% and particularly preferred from 5 to 25 mol-% of the monomeric units of said copolymer contain at least one acidic group.

The acidic group according to the present invention preferably is a carboxylic acid group (-COOH), a carboxylic anhydride group (-(CO)O(CO)-), a sulfo group ($-SO_3H$), an imido group (HN=), a phosphono group ($-PO(OH)_2$), a N-acyl sulfonamido group ($-SO_2NH-COR$), or a phenolic hydroxy group (-phenyl-OH).

Particularly preferred as binders of the present invention are copolymers comprising carboxylic acid groups as acidic group, in particular copolymers containing monomeric units of $\alpha,\beta$-unsaturated carboxylic acids and/or monomeric units of $\alpha,\beta$-unsaturated dicarboxylic acids, preferably acrylic acid, methacrylic acid, crotonic acid, , maleic acid or itaconic acid.

Particular useful examples of copolymers are those containing units of (meth)acrylic acid, itaconic acid and /or crotonic acid together with units of alkyl (meth)acrylates, substituted alkyl (meth)acrylates (such as hydroxyethylmethacrylate), fluoroalkyl (meth)acrylates, allyl (meth)acrylates and/or (meth)acrylonitrile. Also suitable are copolymers containing units of maleic anhydride, maleic acid or maleic acid monoalkyl, alkyleneoxy or aminoalkyleneoxy esters. Among those are, for example, copolymers containing units of maleic anhydride and styrene, unsaturated ethers or esters or unsaturated aliphatic hydrocarbons and the esterification products obtained from such copolymers.

Further suitable binders are products obtainable from the reaction of hydroxyl-containing polymers with intramolecular dicarboxylic anhydrides, such as maleic anhydride or (meth)acrylic anhydride. Further useful binders are polymers in which groups with acidic hydrogen atoms are present, which have been modified by reaction of $-CO_2H$, -OH or $-NH_2$ groups with, for example isocyanate, hydroxy, carboxy or epoxy group containing compounds. Also suitable are polymers with aliphatic or aromatic hydroxyl groups, for example copolymers containing units of hydroxyalkyl (meth) acrylates, allyl alcohol, hydroxystyrene or vinyl alcohol, as well as epoxy resins, provided they carry a sufficient number of free OH groups.

The organic polymers used as binders have a typical mean molecular weight $M_w$ between 600 and 2000000, preferably between 1000 and 500000. Preference is further given to polymers having an acid number between 10 to 250, preferably 20 to 200, or a hydroxyl number between 50 and 750, preferably between 100 and 500.

In a preferred embodiment of the present invention the photopolymerizable composition comprises a radical stabilizer. Said radical stabilizer can be selected from known radical stabilizers. Compounds useful as radical stabilizers of the present invention are also known as antioxidants or radical scavengers that are used as additives for e.g. polymers. Preferably the radical stabilizer used in the present invention is a compound selected from the group consisting of phenoles, organic phosphites, organic phosphonites, amines, hydroxylamines, lactones, hydrochinones, divalent sulfur compounds like thioethers and thioesters, metal complexants, wherein phenoles comprise mono-, di- and trihydroxyphenyl compounds, and in particular the radical stabilizer used in the present invention is a compound selected from the group consisting of hindered phenoles, O-alkylated hydrochinones, organic phosphites, organic phosphonites, aromatic amines, hindered amines, dialkyl hydroxylamines, benzofuranones and dialkyl thiodipropionates.

The radical stabilizers are preferably incorporated in the photopolymerizable composition of the present invention in an amount of 0.01 to 5 wt.%, in particular from 0.015 to 3 wt.%, with respect to the total weight of the non-volatile compounds of the photopolymerizable composition.

A sensitizing dye (sensitizer) preferably used in the present invention, when incorporated in the photopolymerizable composition, has an absorption wavelength ranging from 300 to 1200 nm, preferably from 300 to 600 nm and particularly preferred from 350 to 450 nm, and makes the photopolymer printing plate sensitive to light within said wavelength ranges.

In a preferred embodiment of the present invention, a sensitizer having a solubility in methyl ethyl ketone of at least 15 g/kg, preferably from 15 to 250 g/kg, measured at 20°C is used.

The known sensitizing dyes can be used in the composition of the present invention. Suitable classes include dialkylaminobenzene compounds like (Ia) and (Ib)

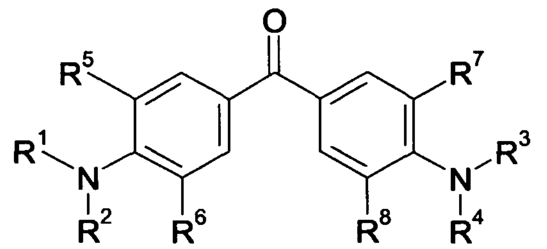

(Ia)

wherein each of $R^1$ to $R^4$, which are independent of one another, is an alkyl group having 1 to 6 carbon atoms ($C_{1-6}$ alkyl group), and each of $R^5$ to $R^8$ is a hydrogen atom or a $C_{1-6}$ alkyl group, provided that $R^1$ and $R^2$, $R^3$ and $R^4$, $R^1$ and $R^5$, $R^2$ and $R^6$, $R^3$ and $R^7$, or $R^4$ and $R^8$, may be bonded to each other to form a ring;

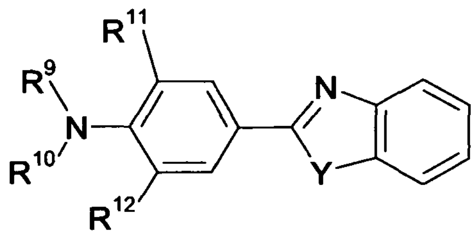

(Ib)

wherein each of $R^9$ and $R^{10}$, which are independent of each other, is a $C_{1-6}$ alkyl group, each of $R^{11}$ and $R^{12}$, which are independent of each other, is a hydrogen atom or a $C_{1-6}$ alkyl group, Y is a sulfur atom, an oxygen atom, dialkylmethylene or -N($R^{13}$)-, and $R^{13}$ is a hydrogen atom or a $C_{1-6}$ alkyl group, provided that $R^9$ and $R^{10}$, $R^9$ and $R^{11}$, or $R^{10}$ and $R^{12}$, may be bonded to each other to form a ring, as disclosed in EP 1 148 387 A1; compounds according to formula (II)

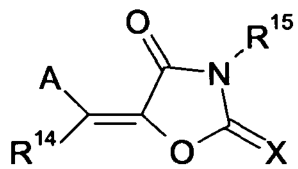

(II),

wherein A represents an optionally substituted aromatic ring or heterocyclclic ring, X represents an oxygen atom, a sulfur atom or -N($R^{16}$)-, $R^{14}$, $R^{15}$ and $R^{16}$ each independently represent a hydrogen atom or a monovalent nonmetallic atom group and A and $R^{14}$, or $R^{15}$ and $R^{16}$ can be linked together to form an aliphatic or an aromatic ring, as disclosed in EP 1 280 006 A2; 1,3-dihydro-1-oxo-2H-indene compounds as disclosed in EP 1 035 435 A2; the sensitizing dyes disclosed in EP 1 048 982 A1, EP 985 683 A1, EP 1 070 990 A1 and EP 1 091 247 A2; and / or an optical brightening agent.

To achieve a very high sensitivity, an optical brightening agent as a sensitizer is preferred. A typical optical brightener, also known as "fluorescent whitening agent", is a colorless to weakly colored organic compound that is capable of absorbing light having a wavelength in the range from 300 to 450 nm and of emitting the absorbed energy

as fluorescent light having a wavelength in the range between 400 and 500 nm. A description of the physical principle and the chemistry of optical brighteners is given in Ullmann's Encyclopedia of Industrial Chemistry, Sixth Edition, Electronic Release, Wiley-VCH 1998. Basically, suitable optical brightener contain $\pi$-electron systems comprising a carbocyclic or a heterocyclic nucleus. Suitable representatives of these compounds are e. g. stilbenes, distyrylbenzenes, distyrylbiphenyls, divinylstilbenes, triazinylaminostilbenes, stilbenyltriazoles, stilbenylnaphthotriazoles, bis-triazolstilbenes, benzoxazoles, bisphenylbenzoxazoles, stilbenylbenzoxazoles, bis-benzoxazoles, furans, benzofurans, bis-benzimidazoles, diphenylpyrazolines, diphenyloxadiazoles, coumarins, naphthalimides, xanthenes, carbostyrils, pyrenes and 1,3,5-triazinyl-derivatives, and divinylfluorene compounds.

More specifically, optical brightening agent having a structure according to one of the following formulae are suitable as sensitizer for use in the composition of the present invention :

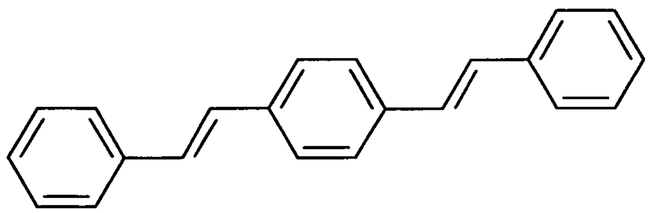

(III)

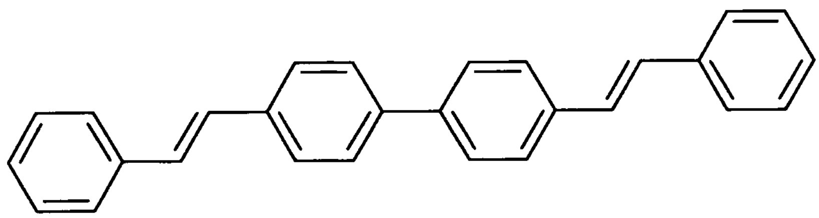

(IV)

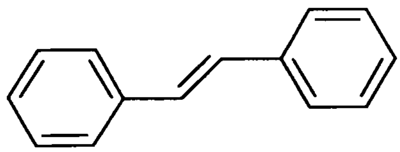

(V)

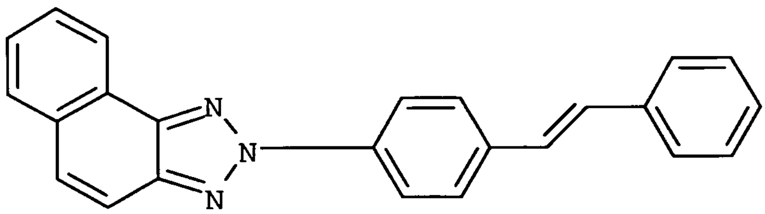

(VI)

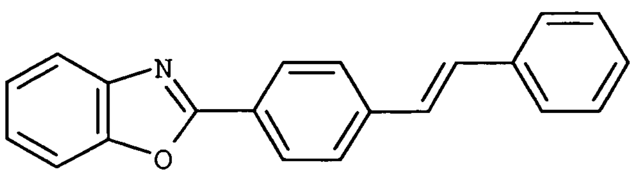

(VII)

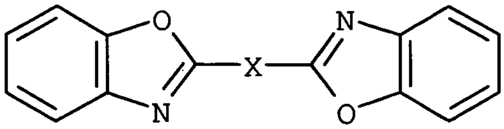

(VIII)

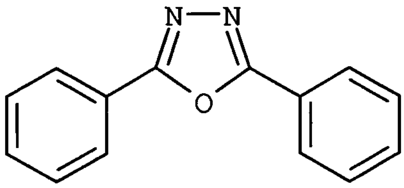

(IX)

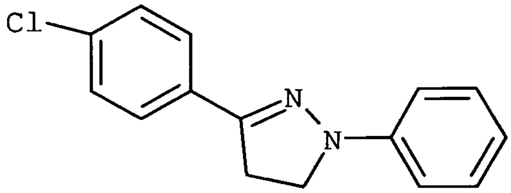

(X)

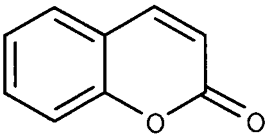

(XI)

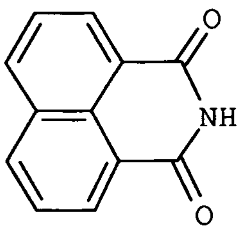

(XII)

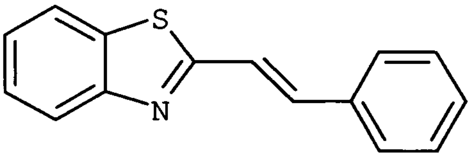

(XIII)

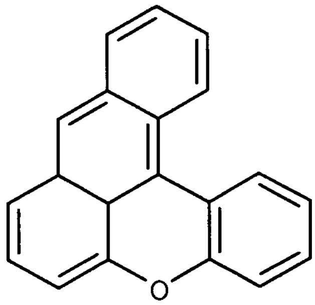

(XIV)

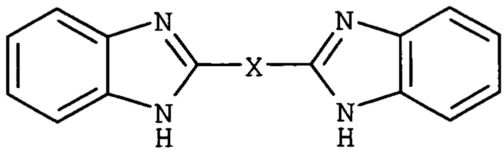

(XV)

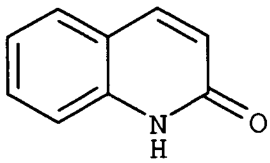

(XVI)

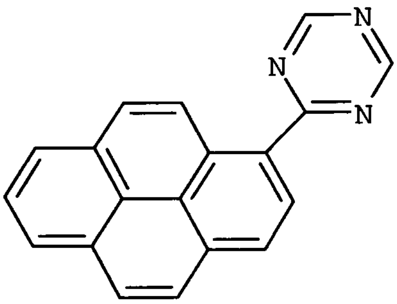

(XVII)

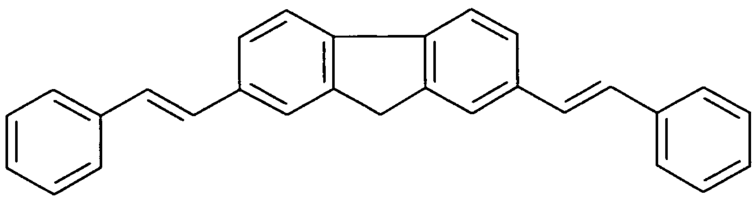

(XVIII)

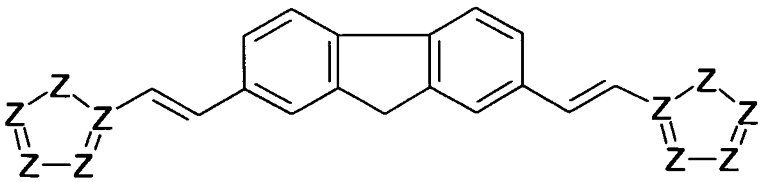

(XIX)

wherein Z mutually independently means non-hydrogen, non-metallic atoms, wherein X is one of the following groups, * denoting the position of attachment in the above formulae:

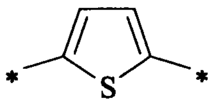

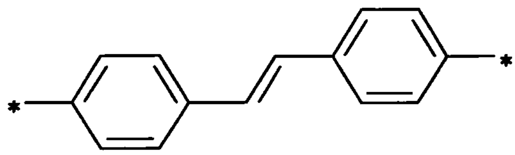

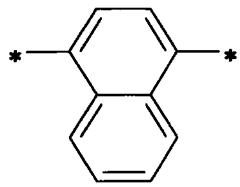

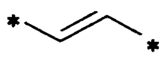

and wherein one or more of the nuclei in each of the above formulae (III) to (XIX) may be independently substituted by one or more groups selected from alkyl, alkoxy, alkylcarbonyl, alkoxycarbonyl, acyloxy, carboxyl, nitrile, amino, hydroxyl, alkylsulfonyl and aminosulfonyl.

Especially suitable optical brighteners are compounds, which are able to be dissolved in organic solvents. The optical brighteners can be used as single compound or as mixture of several materials. The overall amount of these compounds range from 0.1 to 10 % by weight, preferably 0.5 to 8 % by weight with respect to the total weight of the non-volatile compounds in the photopolymerizable composition.

Highly preferred optical brighteners include compounds of formula (III-A) to (XII-A) and (XIV-A) to (XVII-A) :

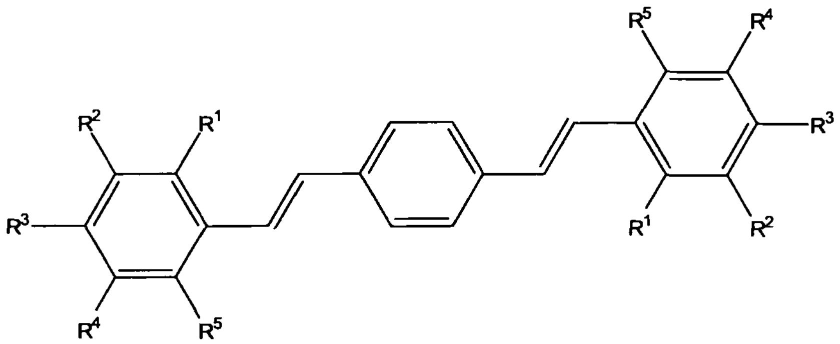

**(III-A)**

wherein

a) $R^1$ represents methyl, and $R^2$ to $R^5$ each represent H,
b) $R^2$ to $R^4$ represent methoxy, and $R^1$ and $R^5$ represent H,
c) $R^1$ represents CN, and $R^2$ to $R^5$ each represent H or
d) $R^3$ represents CN, and $R^1$, $R^2$, $R^4$ and $R^5$ each represent H;

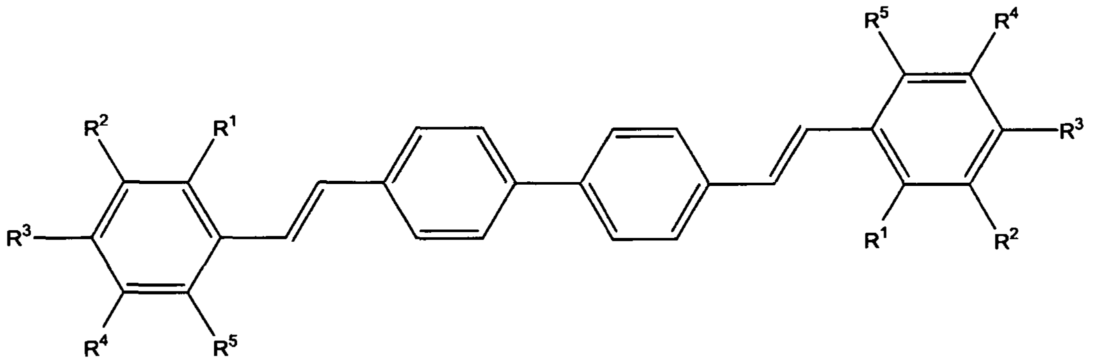

(IV-A)

wherein $R^1$ to $R^4$ each represent H, and $R^5$ represents methoxy;

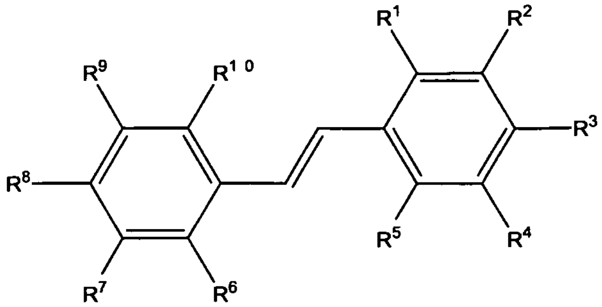

(V-A)

wherein

a) $R^1$ to $R^{10}$ each represent H,
b) $R^1$, $R^2$ and $R^4$ to $R^{10}$ each represent H, and $R^3$ represents methoxy or
c) $R^1$, $R^2$, $R^4$ to $R^7$, $R^9$ and $R^{10}$ each represent H, and $R^3$ and $R^8$ each represent methoxy;

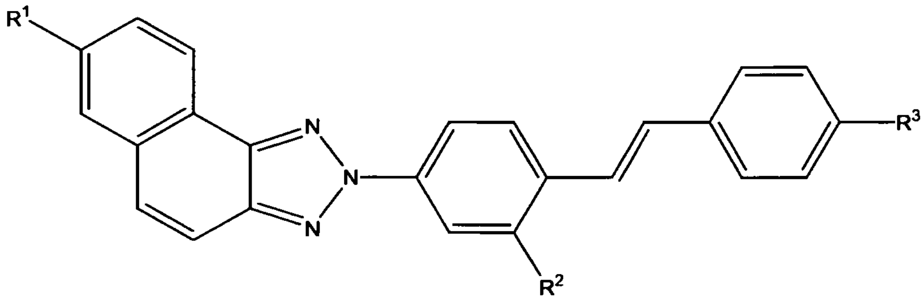

(VI-A)

wherein

a) $R^1$ and $R^3$ represent H, and $R^2$ represents phenylsulfonic acid or phenylsulfonic acid salts or
b) $R^1$ represents H, $R^2$ represents CN and $R^3$ represents Cl;

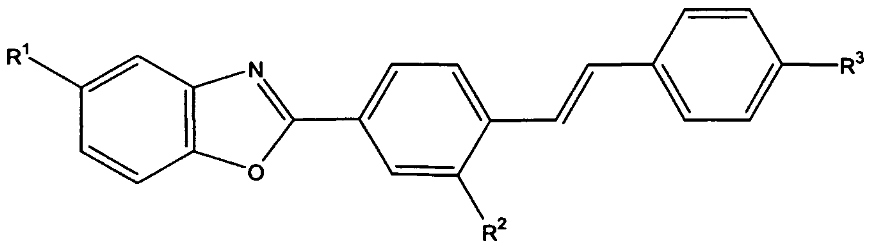

(VII-A)

wherein

a) $R^1$ represents t-butyl, $R^2$ represents H and $R^3$ represents phenyl,
b) $R^1$ represents methyl, $R^2$ represents H, and $R^3$ represents carboxymethyl or
c) $R^1$ represents H, $R^2$ represents H, and $R^3$ represents 2-(4-methyl-oxa-3,3-diazole);

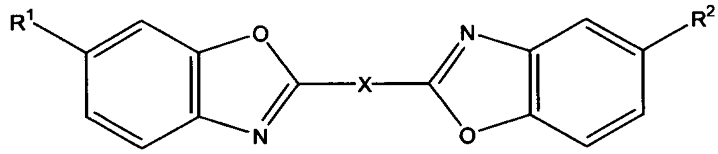

(VIII-A)

wherein

a) X represents 4,4'-stilbenediyl, and $R^1$ and $R^2$ each represent H,
b) X represents 2,5-thiophenediyl, and $R^1$ and $R^2$ each represent t-butyl,
c) X represents 1,4-naphthalenediyl, and $R^1$ and $R^2$ each represent H or
d) X represents 1,1-ethenediyl, and $R^1$ and $R^2$ each represent methyl;

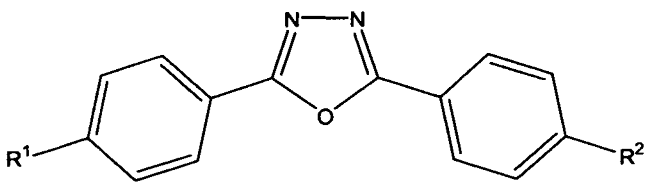

(IX-A)

wherein $R^1$ and $R^2$ each represent diethylamino;

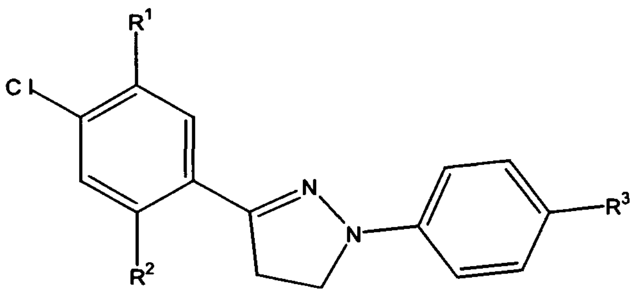

(X-A)

wherein

a) $R^1$ and $R^2$ each represent H, and $R^3$ represents $SO_2NH_2$,
b) $R^1$ and $R^2$ each represent H, and $R^3$ represents $SO_2CH_2CH_2OCH_2CH_2N\ (CH_3)_2$,
c) $R^1$ and $R^2$ each represent H, and $R^3$ represents $SO_2CH_2CH_2OCH\ (CH_3)\ CH_2N\ (CH_3)_2$,

d) $R^1$ and $R^2$ each represent H, and $R^3$ represents $SO_2CH_3$ or
e) $R^1$ and $R^2$ each represent H, and $R^3$ represents $SO_2CH_2CH_2OH$;

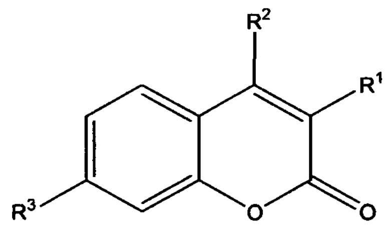

(XI-A)

wherein

a) $R^1$ represents H, $R^2$ represents Me, and $R^3$ represents diethylamino,
b) $R^1$ represents phenyl, $R^2$ represents H, and $R^3$ represents 2-N-naphthatriazolyl,
c) $R^1$ represents H, $R^2$ represents methyl, and $R^3$ represents OH,
d) $R^1$ represents phenyl, $R^2$ represents H, and $R^3$ represents NH-(4,6-dichloro)-(1,3,5)-triazine or
e) $R^1$ represents Ph, $R^2$ represents H, and $R^3$ represents 1-(3-methylpyrazolinyl);

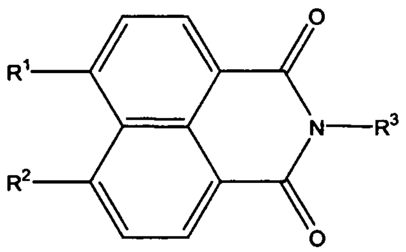

(XII-A)

wherein

a) $R^1$ represents H, $R^2$ represents methoxy, and $R^3$ represents methyl; or
b) $R^1$ and $R^2$ each represent OEt, and $R^3$ represents methyl;

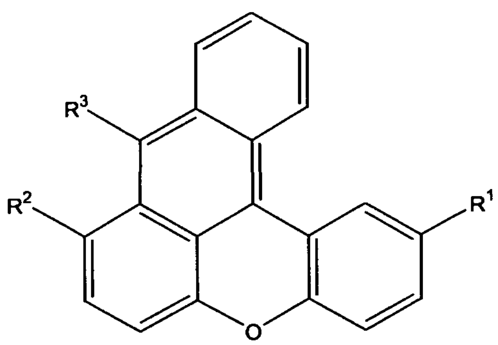

(XIV-A)

wherein

a) $R^1$ and $R^2$ each represent methyl, and $R^3$ represents H or
b) $R^1$ and $R^2$ each represent methyl, and $R^3$ represents carboxymethyl;

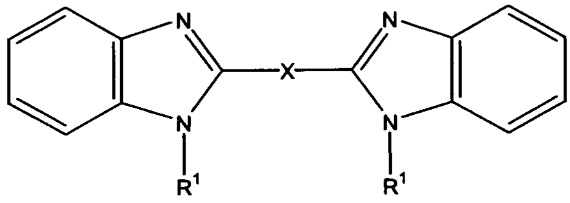

(XV-A)

wherein

a) X represents 1,2-ethenediyl, and $R^1$ represents Me or
b) X represents 4,4'-stilbenediyl, and $R^1$ represents methyl;

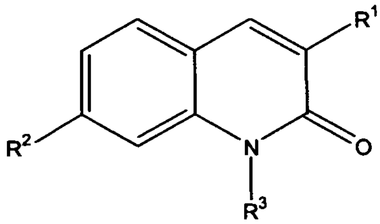

(XVI-A)

wherein $R^1$ represents Ph, $R^2$ represents diethylamino, and $R^3$ represents ethyl; and

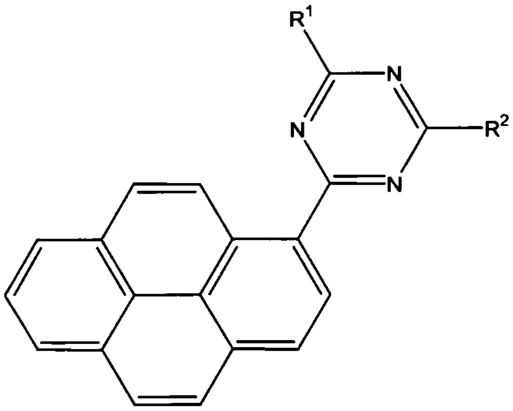

(XVII-A)

wherein $R^1$ and $R^2$ each represent methoxy.

From those sensitizers, the following compounds of formulae (IIIa) and/or (IVa) are particularly preferred:

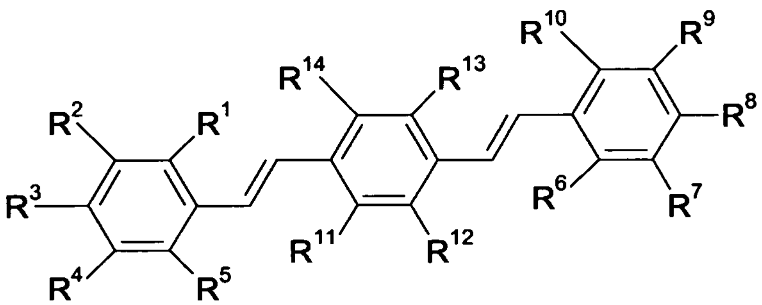

(IIIa),

wherein

$R^1$ to $R^{14}$ in dependently represent a hydrogen atom, an alkyl group, an alkoxy group, a cyano group or a halogen atom, and at least one of $R^1$ to $R^{10}$ represents an alkoxy group having more than 1 carbon atom;

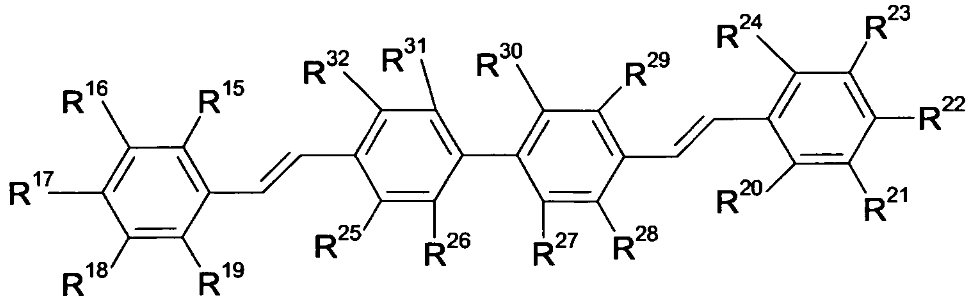

(IVa),

wherein

$R^{15}$ to $R^{32}$ independently represent a hydrogen atom, an alkyl group, an alkoxy group, a cyano group or a halogen atom, and at least one of $R^{15}$ to $R^{24}$ represents an alkoxy group having more than 1 carbon atom. The alkyl and alkoxy groups of the present invention can be optionally substituted and their substituent can be selected to adjust the solubility of the sensitizer and may be, for example, halogen, ester, ether, thioether or hydroxy. The alkyl or alkoxy groups may be straight chain or cyclic, but a branched chain is preferred for the sensitizers of formulae (IIIa) and (IVa).

Particular advantages are achieved with sensitisers of formula (IIIa), wherein $R^1$, $R^5$, $R^6$, $R^{10}$, $R^{11}$, $R^{12}$, $R^{13}$ and $R^{14}$ independently represent a hydrogen atom, a fluorine atom or a chlorine atom, in particular $R^1$, $R^5$, $R^6$, and $R^{10}$ being a hydrogen atom; $R^2$ to $R^4$, $R^7$ to $R^9$, independently are alkoxy groups; and at least two of the alkoxy groups are branched and have from 3 to 15 carbon atoms. Especially preferred for the present invention are sensitizers of formulae (IIIa) as disclosed above, wherein $R^2$, $R^4$, $R^7$, $R^9$ independently represent a methoxy group and $R^3$ and $R^8$ independently are branched alkoxy groups having 3 to 15 carbon atoms.

Particular advantages are also achieved with sensitisers of formula (IVa), wherein $R^{15}$, $R^{19}$, $R^{20}$, $R^{24}$, $R^{25}$ to $R^{32}$, independently represent a hydrogen atom, a fluorine atom or a chlorine atom, in particular $R^{15}$, $R^{19}$, $R^{20}$, $R^{24}$ being a hydrogen atom; $R^{16}$ to $R^{18}$, $R^{21}$ to $R^{23}$, independently are alkoxy groups; and at least two of the alkoxy groups are branched and have from 3 to 15 carbon atoms. Especially preferred for the present invention are sensitizers of formulae (IVa) as disclosed above, wherein $R^{16}$, $R^{18}$, $R^{21}$, $R^{23}$ independently represent a methoxy group and $R^{17}$ and $R^{22}$ independently are branched alkoxy groups having 3 to 15 carbon atoms.

The following structures are examples of preferred sensitizers of the present invention and their solubility S is given in brackets as g sensitizer/kg methyl ethyl ketone measured at 20°C.

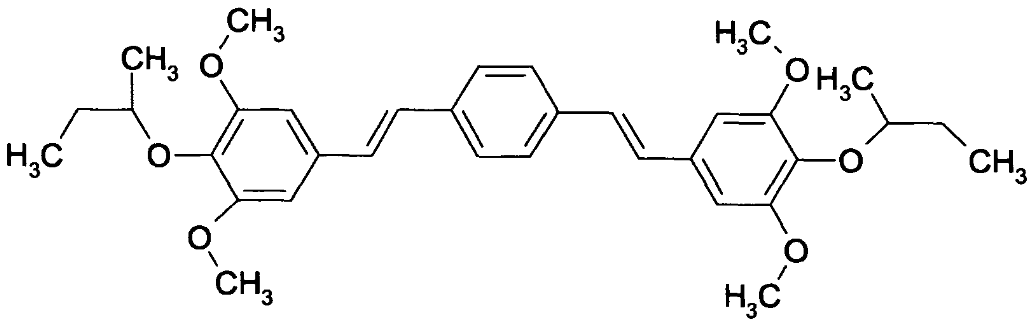

(III-1)
[S = 40]

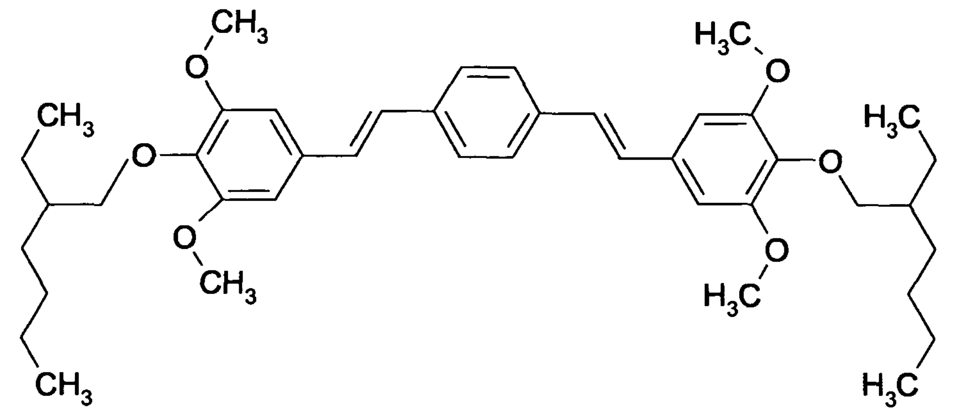

(III-2) [S = 200]

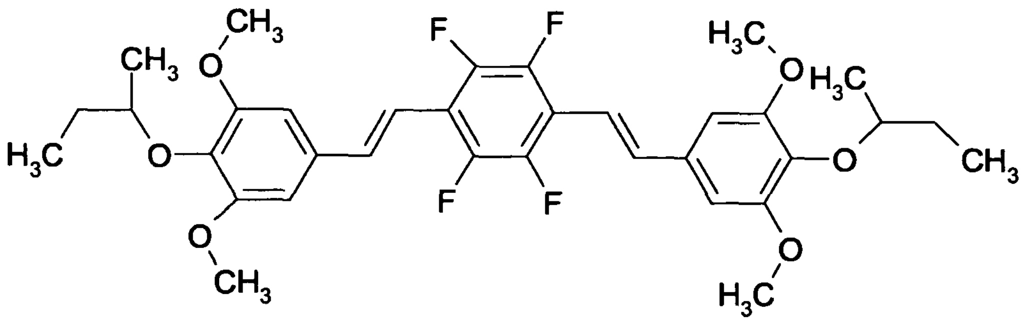

(III-3) [S = 40]

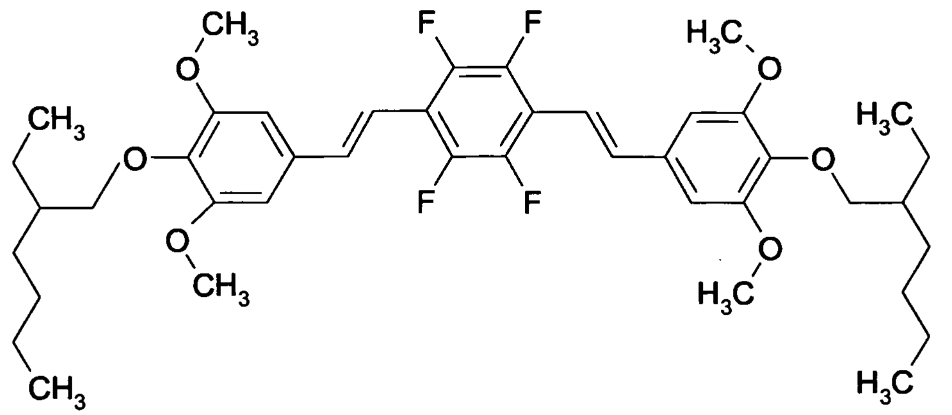

(III-4) [S = 200]

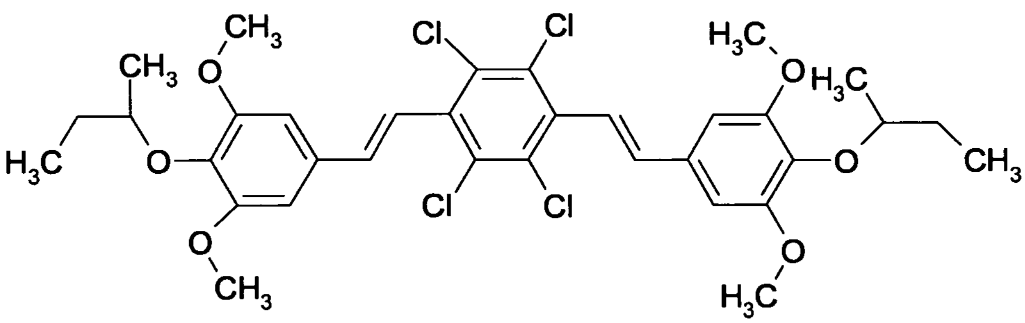

(III-5) [S = 8]

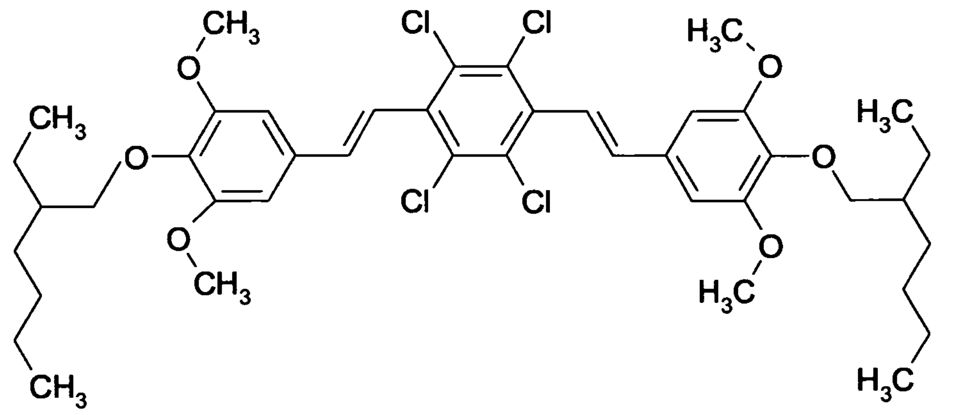

(III-6)

[S = 60]

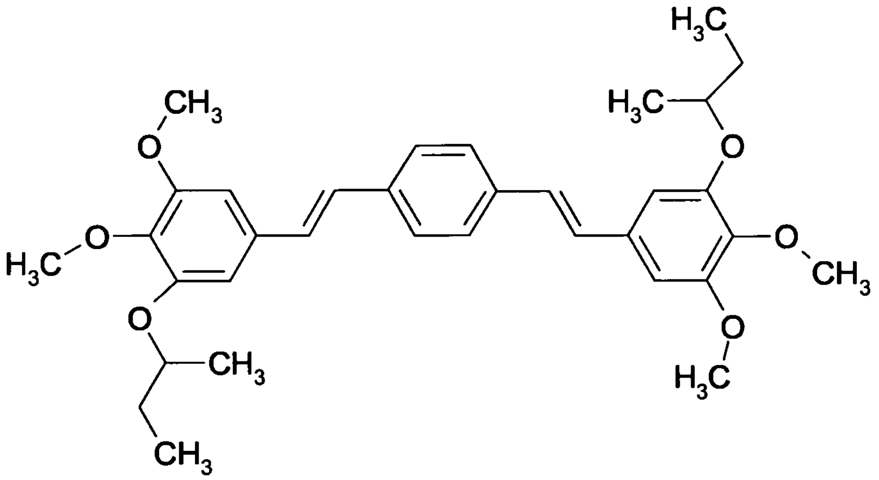

(III-7)

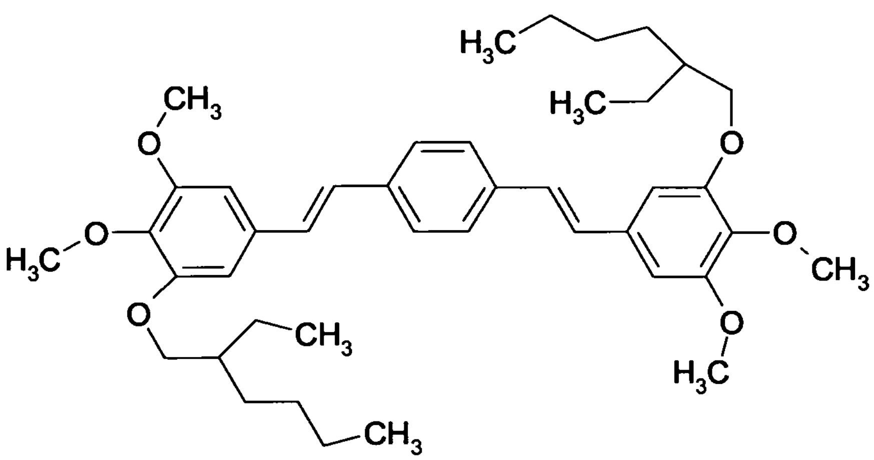

(III-8)

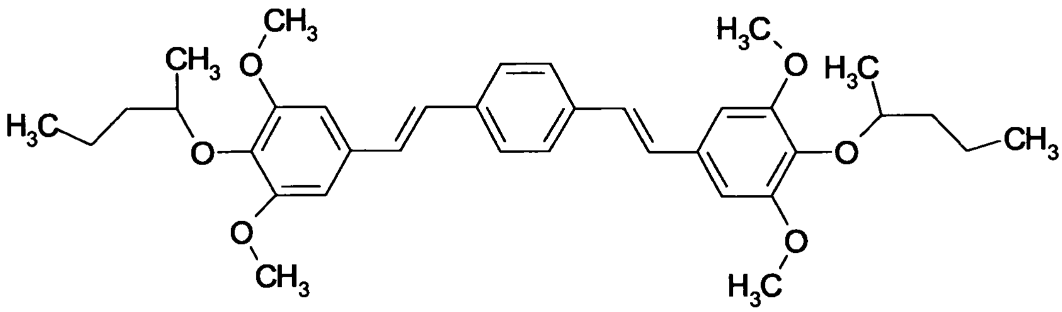

(III-9) [S = 60]

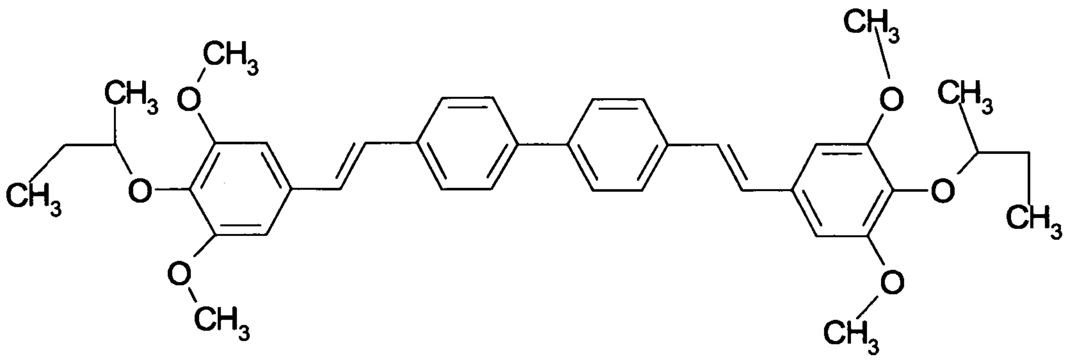

(IV-1) [S = 80]

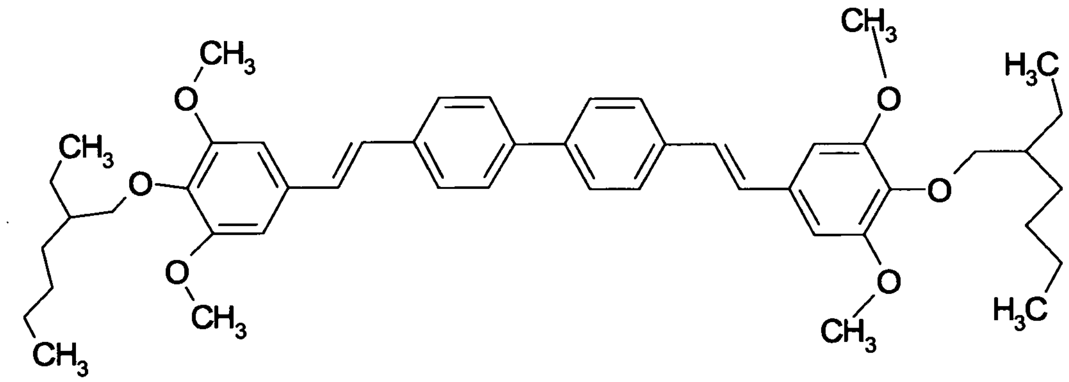

(IV-2) [S = 150]

Most sensitizers useful for the present invention can be synthesised by known methods and the synthesis of the highly preferred sensitizers of formulae (IIIa) and (IVa) can be done in analogy to the synthesis of sensitizer (III-1) as disclosed in the following.

**Synthesis of intermediate (C-3)**

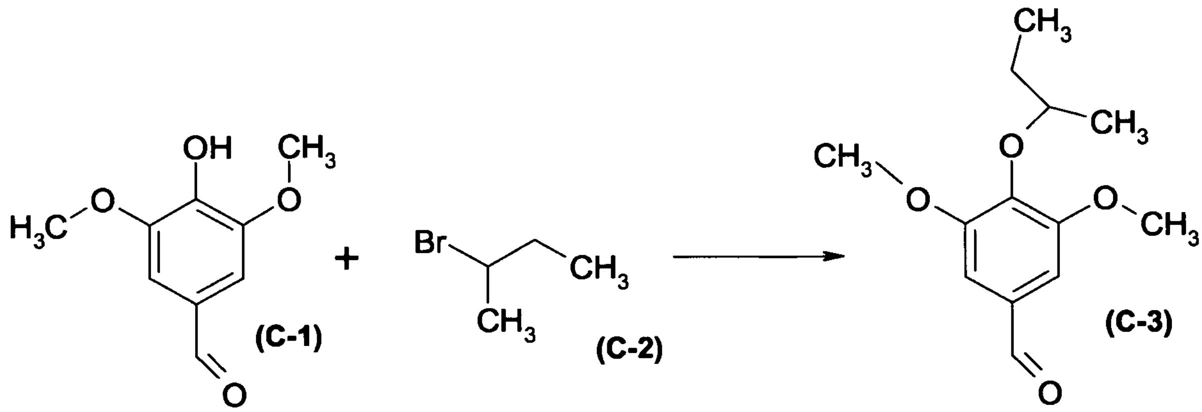

(C-1) (C-2) (C-3)

To a mixture of 8.365 kg (45.0 mol) syringaldehyde **(C-1)** and 1.494 kg (9.0 mol) potassium iodide is added 20.25 L sulfolane at room temperature. After heating up this mixture to 30°C under nitrogen, 3.12 kg (47.25 mol) of KOH in water and 2.80 kg (20.25 mol) $K_2CO_3$ are added. After warming the reaction mixture to 75°C, 12.78 kg (90.0 mol) 2-bromo butane **(C-2)** is added over a period of 30 minutes. Heating at 75°C is continued for 24 hours, followed by cooling to 25°C. Then 25 L Water is added and the reaction product is extracted with 18 L methyl t-butyl ether (MTBE). The organic phase is consecutively a) two times washed with 6.0 L of a 7.5 wt.% $K_2CO_3$ solution in water respectively, b) two times washed with 13.5 L of pure water respectively and finally, c) two times washed with 4.5 kg of a 20 wt.% NaCl solution in water respectively. The solvent (MTBE) is removed by distillation under reduced pressure of 50 mBar at 75°C and thereby are obtained 7.845 kg (theoretical yield of 75 %) of the crude intermediate **(C-3)** as a yellow oil, that is used in the synthesis of **(III-1)** without further purification.

**Synthesis of sensitizer (III-1)**

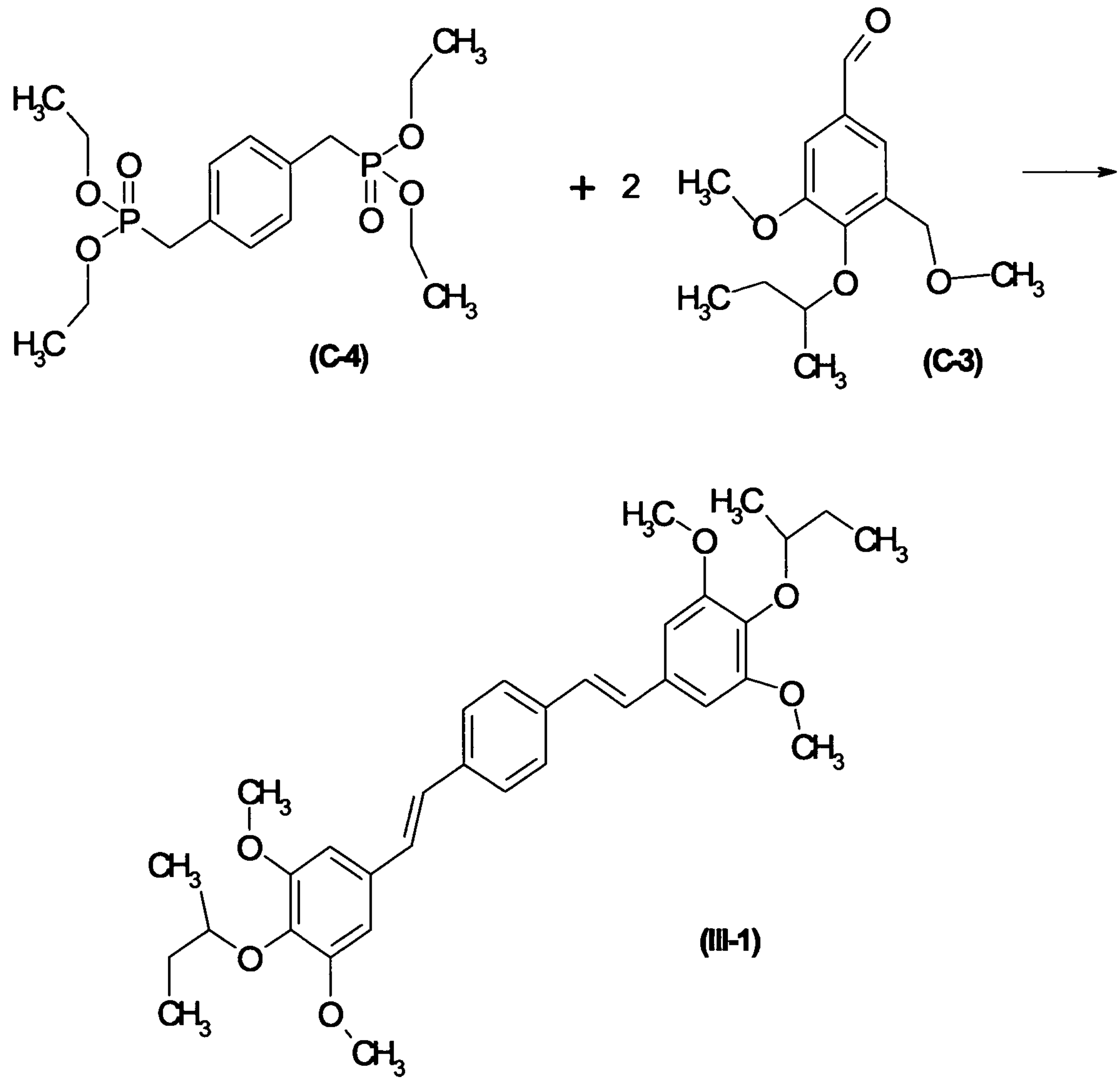

(C-4)

(C-3)

(III-1)

To a mixture of 9.63 kg (25.46 mol) p-xylylene-bis-phosphonate (C-4) and 12.13 kg (50.92 mol) of the crude intermediate **(C-3)** in 20 L THF, 4.70 kg (71.3 mol) of KOH is added at room temperature. After heating the stirred reaction mixture at reflux for 3.5 hours, the reaction product is precipitated by adding a mixture of 25.2 kg methanol and 9.9 kg water, followed by further cooling to 20°C. The crystalline product **(III-1)** is filtered off, washed with several portions of methanol/water on the filter and dried at 50°C. The yield is 9.05 kg (theoretical yield of 67 %) of **(III-1)** having a melting point of 154°C.

A suitable synthesis for the p-xylylene-bis-phosphonate **(C-4)** is known from the literature, e.g. from B.P. Lugovkin and B.A. Arbuzov, Doklady Akademii Nauk SSSR (1948), 59, pages 1301 to 1304.

The photopolymerizable composition according to the present invention preferably comprises a hexaarylbisimidazole (HABI; dimer of triaryl-imidazole) compound as a photopolymerization initiator (photoinitiator).

A procedure for the preparation of hexaarylbisimidazoles is described in DE 1470 154 and their use in photopolymerizable compositions is documented in EP 24 629, EP 107 792, US 4 410 621, EP 215 453 and DE 3 211 312. Preferred derivatives are e. g. 2,4,5,2',4',5'-hexaphenylbisimidazole, 2,2'-bis(2-chlorophenyl)-4,5,4',5'-tetraphenylbisimidazole, 2,2'-bis(2-bromophenyl)-4,5,4',5'-tetraphenylbisimidazole, 2,2'-bis(2,4-dichlorophenyl)-4,5,4',5'-tetraphenylbisimidazole, 2,2'-bis(2-chlorophenyl)-4,5,4',5'-tetrakis(3-methoxyphenyl)bisimidazole, 2,2'-bis(2-chlorophenyl)-4,5,4',5'-tetrakis(3,4,5-trimethoxyphenyl)-bisimidazole, 2,5,2',5'-tetrakis(2-chlorophenyl)-4,4'-bis(3,4-dimethoxyphenyl)bisimidazole, 2,2'-bis(2,6-dichlorophenyl)-4,5,4',5'-tetraphenylbisimidazole, 2,2'-bis(2-nitrophenyl)-4,5,4',5'-tetraphenylbisimidazole, 2,2'-di-o-tolyl-4,5,4',5'-tetraphenylbisimidazole, 2,2'-bis(2-ethoxyphenyl)-4,5,4',5'-tetraphenylbisimidazole and 2,2'-bis(2,6-difluorophenyl)-4,5,4',5'-tetraphenylbisimidazole. The amount of the HABI photoinitiator typically ranges from 0.01 to 30 % by weight, preferably from 0.5 to 20 % by weight, relative to the total weight of the non volatile components of the photopolymerizable composition.

The best results, in particular the highest sensitivity, can be obtained by the combination of an optical brightener as sensitizer and a hexaarylbisimidazole as photoinitiator, sensitizers of formulae (III) and (IV) being particularly preferred.

Hexaarylbisimidazole compounds can be used as photoinitiators either alone or in combination with further photoinitiators. The known photopolymerization initiators can be used in the composition of the present invention in combination with hexarylbisimidazole compounds. Suitable classes include aromatic ketones, aromatic onium salts, organic peroxides, thio compounds, ketooxime ester compounds, borate compounds, azinium compounds, metallocene compounds, active ester compounds and compounds having a carbon-halogen bond. Many specific examples of such photoinitiators can be found in EP-A 1091247.

Preferably hexaarylbisimidazole compounds are used alone or in combination with aromatic ketones, aromatic onium salts, organic peroxides, thio compounds, ketoxime ester compounds, borate compounds, azinium compounds, active ester compounds or compounds having a carbon halogen bond.

In a preferred embodiment of the present invention the hexaarylbisimidazole compounds make more than 50 mol-%, preferably at least 80 mol-% and particularly preferred at least 90 mol-% of all the photoinitiators used in the photopolymerizable composition of the present invention.

The polymerizable compound can be selected from a wide series of photo-oxidizable compounds. Suitable compounds contain primary, secondary and in particular tertiary amino groups. Radically polymerizable compounds containing at least one urethane and/or urea group and/or a tertiary amino group are particularly preferred. By the term "urea group" has to be understood in the context of the present invention a group of the formula >N-CO-N<, wherein the valences on the nitrogen atoms are saturated by hydrogen atoms and hydrocarbon radicals (with the proviso that not more than one valence on either of the two nitrogen atoms is saturated by one hydrogen atom). However, it is also possible for one valence on one nitrogen atom to be bonded to a carbamoyl (-CO-NH-) group, producing a biuret structure.

Also suitable are compounds containing a photo-oxidizable amino, urea or thio group, which may be also be a constituent of a heterocyclic ring. Compounds containing photo-oxidizable enol groups can also be used. Specific examples of photo-oxidizable groups are triethanolamino, triphenylamino, thiourea, imidazole, oxazole, thiazole, acetylacetonyl, N-phenylglycine and ascorbic acid groups. Particularly suitable compounds are monomers containing photo-oxidizable groups corresponding to the following formula (PC-I):

$$R_{(m-n)}Q[(-CH_2-CR^1R_2-O)_a-CO-NH-(X^1-NH-CO-O)_b-X^2-(O-CO-CR^3=CH_2)_c]_n \qquad \text{(PC-I)}$$

wherein

R represents an alkyl group having 2 to 8 carbon atoms (($C_2$-$C_8$) alkyl group), a ($C_2$-$C_8$) hydroxyalkyl group or a ($C_6$-$C_{14}$) aryl group,

Q represents -S-,

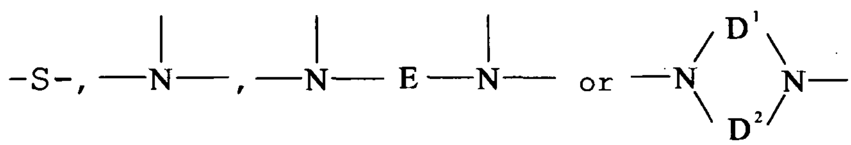

wherein

E represents a divalent saturated hydrocarbon group of 2 to 12 carbon atoms, a divalent 5- to 7-membered, saturated iso- or heterocyclic group, which may contain up to 2 nitrogen, oxygen and/or sulfur atoms in the ring, a divalent aromatic mono- or bicyclic isocyclic group of 6 to 12 carbon atoms or a divalent 5- or 6-membered aromatic heterocyclic group; and

$D^1$ and $D^2$ independently represent a saturated hydrocarbon group of 1 to 5 carbon atoms,

$R^1$ and $R^2$ independently represent a hydrogen atom, an alkyl or alkoxyalkyl group,

$R^3$ represents a hydrogen atom, a methyl or ethyl group,

$X^1$ represents a straight-chained or branched saturated hydrocarbon group of 1 to 12 carbon atoms,

$X^2$ represents a (c+1)-valent hydrocarbon group in which up to 5 methylene groups may have been replaced by oxygen atoms,

a is an integer from 0 to 4,

b is 0 or 1,

c is an integer from 1 to 3,

m is an integer from 2 to 4 and

n is an integer from 1 to m.

Compounds of this nature and processes for their preparation are described in EP 287 818. If a compound of general formula (PC-I) contains several radicals R or several radicals according to the structure indicated between square brackets, i. e. if (n-m) > 1 and n>1, these radicals can be identical or different from one another. Compounds according to formula (PC-I) wherein n = m are particularly preferred. In this case, all radicals contain polymerizable groups. Preferably, the index a is 1; if several radicals are present, a cannot be 0 in more than one radical. If R is an alkyl or hydroxyalkyl group, R generally contains 2 to 6, particularly 2 to 4 carbon atoms. Aryl radicals R are in general mononuclear or binuclear, preferably however mononuclear, and may be substituted with ($C_1$-$C_5$) alkyl or ($C_1$-$C_5$) alkoxy groups. If $R^1$ and $R^2$ are alkyl or alkoxy groups, they preferably contain 1 to 5 carbon atoms. $R^3$ is preferably a hydrogen atom or a methyl group. $X^1$ is preferably a straight-chained or branched aliphatic and/or cycloaliphatic radical of preferably 4 to 10 carbon atoms. In a preferred embodiment, $X^2$ contains 2 to 15 carbon atoms and is in particular a saturated, straight-chained or branched aliphatic and/or cycloaliphatic radical containing this amount of carbon atoms. Up to 5 methylene groups in these radicals may have been replaced by oxygen atoms; in the case of $X^2$ being composed of pure carbon chains, the radical generally has 2 to 12 carbon atoms, preferably 2 to 6 carbon atoms. $X^2$ can also be a cycloaliphatic group of 5 to 10 carbon atoms, in particular a cyclohexane diyl group. The saturated heterocyclic ring formed by $D^1$, $D^2$ and both nitrogen atoms generally has 5 to 10 ring members in particular 6 ring members. In the latter case the heterocyclic ring is preferably a piperazine and the radical derived therefrom a piperazine-1,4-diyl radical. In a preferred embodiment, radical E is an alkane diyl group which normally contains about 2 to 6 carbon atoms. Preferably the divalent 5- to 7-membered, saturated, isocyclic group E is a cyclohexane diyl group, in particular a cyclohexane-1,4-diyl group. The divalent, isocyclic, aromatic group E is preferably an ortho-, meta- or para-phenylene group. The divalent 5- or 6-membered aromatic heterocyclic group E, finally, contains preferably nitrogen and/or sulphur atoms in the heterocyclic ring. c is preferably 1, i. e. each radical in the square bracket generally contains only one polymerizable group, in particular only one (meth)acryloyloxy-group.

The compounds of formula (PC-I) wherein b = 1, which accordingly contain two urethane groups in each of the radicals indicated in the square brackets, can be produced in a known way by conversion of acrylic esters or alkacrylic esters which contain free hydroxyl groups with equimolar amounts of diisocyanates. Excess isocyanate groups are then, for example, reacted with tris(hydroxyalkyl)amines, N,N'-bis(hydroxyalkyl) piperazines or N,N,N',N'-tetrakis(hydroxyalkyl)alkylenediamines, in each of which individual hydroxyalkyl groups may have been replaced by alkyl or aryl groups R. If a = 0, the result is a urea grouping. Examples of the hydroxyalkylamine starting materials are diethanolamine, triethanolamine, tris(2-hydroxypropyl)amine, tris(2-hydroxybutyl)amine and alkyl-bis-hydroxyalkylamines. Examples of suitable diisocyanates are hexamethylene diisocyanate, 2,2,4-trimethylhexamethylene diisocyanate, 1,4-cyclohexylene diisocyanate (= 1,4-diisocyanatocyclohexane) and 1,1,3-trimethyl-3-isocyanatomethyl-5-isocyanatocyclohexane. The hydroxy-containing esters used are preferably hydroxyethyl (meth)acrylate, hydroxypropyl (meth)acrylate and hydroxyisopropyl (meth)acrylate.

The polymerizable compounds of formula (PC-I) wherein b = 0 are prepared converting the above-described hydroxyalkylamino compounds with isocyanate-containing acrylic or alkacrylic esters. A preferred isocyanate-containing ester is isocyanoto-ethyl (meth)acrylate.

Further polymerizable compounds comprising photooxidisable groups suitable for the purpose of the invention are compounds according to the following formula (PC-II):

$$R_{(m-n)}Q[(-CH_2-CR^1R^2-O)_{a'}-(CH_2-CH[CH_2-O-CO-CR^3=CH_2]-O)_{b'}-H]_n \qquad \text{(PC-II)}$$

wherein a' and b' independently represent integers from 1 to 4 and Q, $R^1$, $R^2$, $R^3$, n and m have the same meaning as above and Q can also be a group of the formula >N-E'-N< wherein the radical E' corresponds to the following formula (PC-III):

$$-CH_2-CH\ (OH)\ -CH_2-\ [O-\ (p)\ C_6H_4-C\ (CH_3)_2-(p)\ C_6H_4-CH_2-CH(OH)\ -CH_2-]_c \qquad \text{(PC-III)}$$

wherein c has the same meaning as in formula (I) and $(p)C_6H_4$ represents para-phenylene.

The compounds of formula (PC-II) can be prepared analogously to those of formula (PC-I), except that the conversion products of hydroxyalkyl acrylates or alkacrylates and diisocyanates are replaced by the corresponding acrylic and alkacrylic glycide esters. Compounds of formula (PC-III) and processes to their preparation are disclosed in EP 316 706.

Further useful polymerizable compounds containing photooxidisable groups are acrylic and alkacrylic esters of the following formula (PC-IV):

$$Q'\ [(-X^{1'}-CH_2-O)_a-CO-NH(-X^1-NH-CO-O)_b-X^2-O-CO-CR^3=CH_2]_n \qquad \text{(PC-IV)}$$

wherein

Q' represents

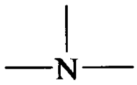 , 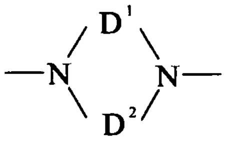 or 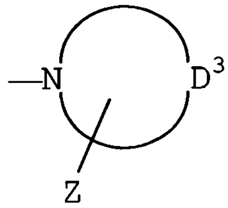

wherein $D^1$ and $D^2$ independently represent a saturated hydrocarbon group of 1 to 5 carbon atoms and $D^3$ represents a saturated hydrocarbon group of 4 to 8 carbon atoms, which together with the nitrogen atom forms a 5- or 6-membered heterocyclic ring;
$X^{1'}$ represents $-C_iH_{2i}-$ or

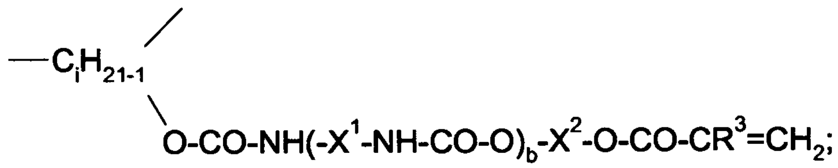

Z represents a hydrogen atom or a radical of the following formula: $-C_kH_{2k}$-O-CO-NH(-$X^1$-NH-CO-O$)_b$-$X^2$-O-CO-$CR^3$=$CH_2$ ;
i,k independently represent integers from 1 to 12;
n' represents an integer from 1 to 3; and
a is 0 or 1; provided that a is 0 in at least one of the radicals bonded to Q;
$X^1$, $R^3$, a and b have the same meaning as given in the above formula (PC-I); and
$X^2$ represents a divalent hydrocarbon group in which up to 5 methylene groups may be replaced by oxygen atoms.

In formula (PC-IV) index a is preferably 0 or 1 and i preferably represents a number between 2 and 10. Preferred radicals Q are piperazine-1,4-diyl ($D^1 = D^2 = CH_2$-$CR_2$), piperidine-1-yl ($D^3 = (CH_2)_5$, Z = H) and 2-(2-hydroxyethyl)-piperidine-1-yl ($D^3 = (CH_2)_5$, Z = $CH_2CH_2OH$).

Of the compounds of formula (PC-IV), those which apart from a urea group contain at least one urethane group are preferred. Here again, by the term "urea group" has to be understood the group of formula >N-CO-N< already mentioned above. Compounds of formula (PC-IV) and processes for their preparation are disclosed in EP 355 387.

Also suitable polymerizable compounds are reaction products of mono- or diisocyanates with multifunctional alcohols, in which the hydroxy groups are partly or completely esterified with (meth)acrylic acid. Preferred compounds are materials, which are synthesized by the reaction of hydroxyalkyl-(meth)acrylates with diisocyanates. Such compounds are basically known and for instance described in DE 28 22 190 and DE 20 64 079.

The amount of polymerizable compound comprising photooxidisable groups generally ranges from 5 to 75 % by weight, preferably from 10 to 65 % by weight, relative to the total weight of the non volatile compounds of the photopolymerizable composition.

Moreover, the composition can contain polyfunctional (meth)acrylate or alkyl(meth)acrylate compounds as crosslinking agents. Such compounds contain more than 2, preferably between 3 and 6 (meth)acrylate and/or alkyl (meth)acrylate groups and include in particular (meth)acrylates of saturated aliphatic or alicyclic trivalent or polyvalent alcohols such as trimethylol ethane, trimethylol propane, pentaerythritol or dipentaerythritol.

The total amount of polymerizable compounds generally ranges from about 10 to 90 % by weight, preferably from about 20 to 80 % by weight, relative to the total weight of the non volatile components of the photopolymerizable composition of the present invention.

The following specific example is a prefered polymerizable compound:

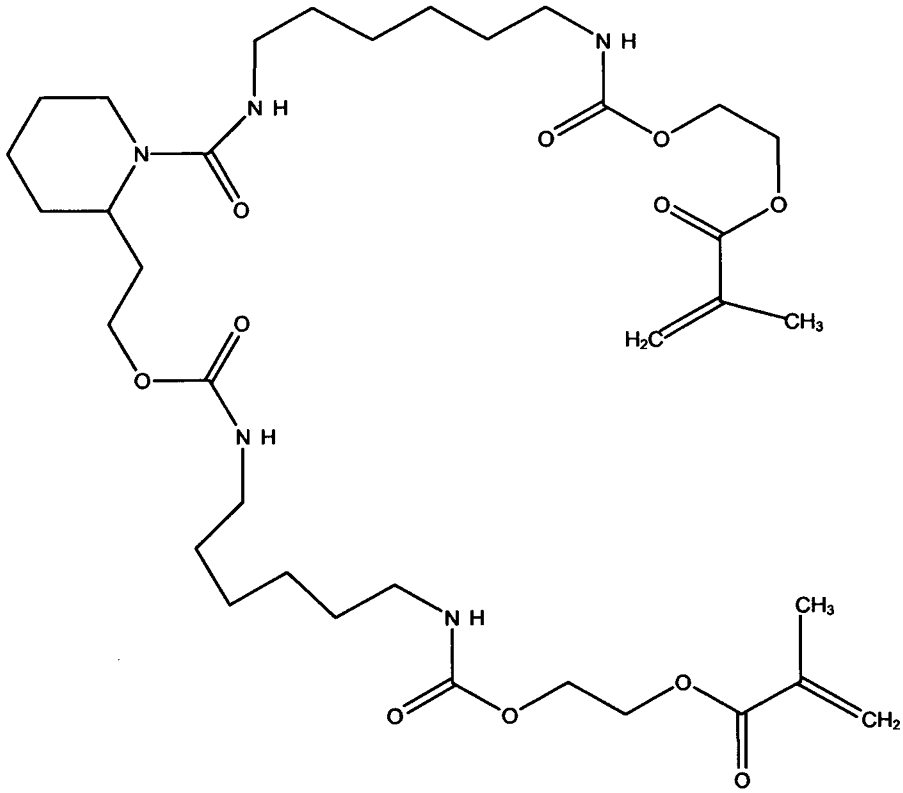

In order to achieve a high sensitivity, it is advantageous to add a radical chain transfer agent as described in EP 107 792 to the photopolymerizable composition of the present invention. The preferred chain transfer agents are sulfur containing compounds, especially thiols like e. g. 2-mercaptobenzothiazole, 2-mercaptobenzoxazole or 2-mercapto-benzimidazole. The amount of chain transfer agent generally ranges from 0.01 to 10 % by weight, preferably from 0.1 to 2 % by weight, relative to the total weight of the non volatile components of the photopolymerizable composition.

Optionally pigments, e.g. predispersed phthalocyanine pigments, can be added to the composition of the present invention for dyeing the composition and the layers produced therewith. Their amount generally ranges from about 1 to 20 % by weight, preferably from 2 to 15 % by weight and particularly preferred from about 2 to 10 % by weight related to the total weight of the non volatile components of the composition. Particularly suitable predispersed phthalocyanine pigments are disclosed in DE 199 15 717 and DE 199 33 139. Preference is given to metal-free phthalocyanine pigments.

In order to adjust the photopolymerizable composition according to the present invention to specific needs, thermal inhibitors or stabilizers for preventing thermal polymerization may be added. Furthermore additional hydrogen donors, dyes, colored or colorless pigments, color formers, indicators and plasticisers may be present. These additives are conveniently selected so that they absorb as little as possible in the actinic range of the imagewise applied radiation.

The photopolymerizable composition according to the present invention is applied to the support by processes which are known per se to the person skilled in the art. In general, the components of the photopolymerizable composition are dissolved or dispersed in an organic solvent or solvent mixture, the solution or dispersion is applied to the intended support by pouring on, spraying on, immersion, roll application or in a similar and the solvents are removed during the subsequent drying.

The known supports can be used for the photopolymer printing plate of the present invention, like e. g. foils, tapes or plates made of metal or plastics and in the case of screen-printing also of Perlon gauze. Preferred metals are aluminium, aluminium alloys, steel and zinc, aluminium and aluminium alloys being particularly preferred. Preferred plastics are polyester and cellulose acetates, polyethyleneterephthalate (PET) being particularly preferred.

In most cases it is preferred, to treat the surface of the support mechanically and/or chemically and/or electrochemically to optimally adjust the adherence between the support and the photosensitive coating and/or to reduce the reflection of the imagewise exposed radiation on the surface of the support (antihalation).

The most preferred support to be used for the present invention is made of aluminium or an aluminium alloy, its surface is electrochemically roughened, thereafter anodized and optionally treated with a hydrophilizing agent like e. g. poly(vinylphosphonic acid) .

In a preferred embodiment of the present invention a protective layer (protective overcoat) is arranged on top of the photosensitive coating. Preferably the protective layer has a dry coating weight of less than 3.0 g/m2, in particular less than 2.5 $g/m^2$, and particularly preferred from more than 0.25 $g/m^2$ to less than 2.5 $g/m^2$.

The protective overcoat preferably comprises at least one type of poly(vinyl alcohol), in particular a poly(vinyl alcohol) wherein the mean degree of saponification is less than 93 mol-%.

The degree of saponification is related to the production of poly(vinyl alcohols). As the monomer of poly(vinyl alcohol), vinyl alcohol, is nonexistent, only indirect methods are available for the production of poly(vinyl alcohol). The most important manufacturing process for poly(vinyl alcohol) is the polymerization of vinyl esters or ethers, with subsequent saponification or transesterification. The preferred starting material for the poly (vinyl alcohol) of the present invention is a vinyl alcohol esterified by a mono carboxylic acid and in particular vinyl acetate, but derivatives of vinyl acetate, vinyl esters of di carboxylic acids, vinyl ethers and the like can also be used. The degree of saponification as defined for the present invention is the molar degree of hydrolysis irrespective of the process used for the hydrolysis. Pure poly(vinyl alcohol) has e. g. a degree of saponification of 100 mol-%, but commercial products often have a degree of saponification of 98 mol-%. The poly(vinyl alcohols) as used for the present invention contain mainly 1,3-diol units, but may also contain small amounts of 1,2-diol units. In the partially saponified poly(vinyl alcohols) the ester or the ether group can be distributed statistically or blockwise. Preferred partially saponified poly(vinyl alcohols) of the present invention have a viscosity of a 4 % aqueous solution at 20°C of 4 to 60 mPa•s, preferably of 4 to 20 mPa•s and in particular of 4 to 10 mPa•s.

Poly(vinyl alcohols) preferred for the present invention are commercially available e. g. under the tradename Mowiol. Those products are characterised by two appended numbers, meaning the viscosity and the degree of saponification. For example, Mowiol 8 - 88 or Mowiol 8/88 mean a poly(vinyl alcohol) having as 4 % aqueous solution at 20°C a viscosity of ca 8 mPa·s and a degree of saponification of 88 mol-%. Although the use of only one type of poly(vinyl alcohol) is sufficient to achieve an advantage, it is preferred to use a mixture of two or more compounds, because this allows a more accurate adjustment and a better optimization of further properties of the printing plate precursor. Preferably poly(vinyl alcohols) differing in viscosity as defined above and/or in saponification degree are combined. Particularly preferred are mixture of poly(vinyl alcohols) that differ in viscosity of their 4 % aqueous solutions at 20°C for at least 2 mPa•s or that differ in saponification degree for at least 5 mol-%. Most preferred are mixtures comprising at least 3 types of poly(vinyl alcohols), wherein at least two compounds differ in viscosity as defined above for at least 2 mPa·s and at least two compounds differ in saponification degree for at least 5 mol-%.

According to a preferred embodiment of the present invention the overall mean saponification degree of all poly(vinyl alcohols) used in the protective layer has to be less than 93 mol-%. In a particular preferred embodimend of the present invention said overall mean saponification degree ranges from 71 mol-% to less than 93 mol-% and in particular from 80 mol-% to 92,9 mol-%.

As long as said mean overall saponification limit of 93 mol-% is not reached, one of the poly(vinyl alcohols) used in a mixture can have a mean saponification degree of more than 93 mol-% and even up to 100 mol-%.

The overall mean saponification degree of the poly(vinyl alcohols) used in the protective overcoat of a printing plate precursor can be determined experimentally via $^{13}C$-NMR. To measure the $^{13}C$-NMR spectra, approximately 200 mg of the protective overcoat are dissolved in 1.0 ml DMSO and from this solution a 75 MHz $^{13}C$-NMR spectrum is taken, whose resonances can easily be interpreted and allow to calculate the degree of saponification. Such values are listed in the Examples, in Table 3, as experimental values. A good correlation is obtained between said experimental values and the values known from the product specification of the poly(vinyl alcohols). The latter values are hereinafter called theoretical values of the mean saponification degree and can easily be calculated, when mixture of poly(vinyl alcohols) are used.

Preferably poly(vinyl alcohol)s are used for the present invention in 50 to 99.9 weight percent (wt.%) relative to the total weight of the non-volatile compounds of the protective overcoat.

Apart from poly(vinyl alcohol)s other water soluble polymers can be added to the layer such as poly(vinyl pyrrolidone), poly(ethylene oxide), gelatin, gum arabic, oxygen binding polymers with aliphatic amine groups known from EP 352 630 B1, methyl vinylether/maleic anhydride copolymers, poly(carboxylic acids), copolymers of ethylene oxide and poly(vinyl alcohol), carbon hydrates, hydroxy ethyl cellulose, acidic cellulose, cellulose, poly(arylic acid)and mixtures of these polymers.

Preferably the poly(vinyl pyrrolidone) is only used in small quantities compared to the poly(vinyl alcohol). In a preferred embodiment of the present invention poly(vinyl pyrrolidone) is used from 0 to 10 parts by weight of the poly (vinyl alcohol) used, from 0 to 3 parts by weight being particularly preferred. Most preferred no poly(vinyl pyrrolidone) compounds are used.

In addition to the poly(vinyl alcohol) of the present invention and the optional water soluble polymers disclosed above, the known ingredients of protective layers can be used.

Examples of known ingredients suitable for the protective layer of the present invention are surface wetting agents, coloring agents, complexants, polyethylenimines and biocides.

The protective layer has to be transparent for actinic light. Preferably it is homogeneous, substantially impermeable to oxygen, waterpermeable, and can be washed off preferably with the conventional developer solutions used to form a printing relief after imagewise exposure of the photosensitive layer. Said photosensitive layer is removed imagewise, whereas the protective layer is removable over the entire area of the element created. The wash-off of the protective layer can be done in a separate step, but can be done during the development step as well.

The dry coating weight of the protective overcoat can be measured by the following procedure. A plate is exposed for 4 hours to daylight. Next the plate is pre-heated between 104°C and 127°C (temperature measured via a thermostrip (THERMAX commercially available from TMC) at the back of the plate). The plate is cut to a size of 100 mm X 100 mm and weighted on an analytical balance with 0.01 mg accuracy (=Weight A). Next the protective overcoat is washed off with water (25°C) for 2 minutes. Than the plate is rinsed with demineralised water and dried in an oven at 100°C. After drying the plate is allowed to cool down to room temperature, and the weight is determined using the same analytical balance as described earlier (=Weight B). The dry coating weight in g/m$^2$ of the protective overcoat is calculated using the formula below :

$$\text{Dry coating weight } (g/m^2) = 100 \text{ X } (\text{Weight A} - \text{Weight B})$$

The protective layer can be coated on the photosensitive layer with known techniques and the coating solution preferably contains water or a mixture of water and an organic solvent. To allow a better wetting, the coating solution preferably contains, related to the solid content, up to 10 wt.%, and particular preferred up to 5 wt.% of a surface active agent. Suitable representatives of surface active agents comprise anionic, cationic and nonionic surface active agents like sodium alkylsulfates and -sulfonates having 12 to 18 carbon atoms, an example of which is sodium dodecylsulfate, N-cetyl- and C-cetyl betaine, alkylaminocarboxylate and -dicarboxylate, and polyethylene glycols with a mean molar weight up to 400.

In addition, further functions can be added to the protective layer. For example, it can be possible to improve the safelight suitability without decreasing the sensitivity of the layer by adding a coloring agent, e. g. a water-soluble dye, that has excellent transmission to the light having a wavelength of 300 to 450 nm and that absorbs the light having a wavelength of 500 nm or more. This principle can easily be varied for different wavelengths to adjust the effective spectral sensitivity distribution of the printing plate precursor as needed.

The present invention also relates to a method of making a lithographic printing plate comprising the steps of providing a photopolymer printing plate precursor as defined above, exposing said printing plate precursor, and processing the printing plate precursor in an aqueous alkaline developer.

In a preferred embodiment of the method of the present invention the exposure is done with a laser having an emission wavelength in the range from 300 to 1200 nm, in particular in the range from 300 to 600 nm, and particularly preferred in the range from 350 to 450 nm, and the exposure preferably is carried out at an energy density, measured on the surface of the plate, of 100 μJ/cm$^2$ or less.

The processing of the printing plate precursor of the present invention is done in the usual manner. After imagewise exposure a pre-heat step can be performed to improve the crosslinking of the photosensitive layer, but preferably no pre-heat step is carried out. Then usually follows the development step, wherein the optional overcoat layer and the unexposed part of the photosensitive layer are removed. The removal (wash-off) of the overcoat layer and the development of the photosensitive layer can be done in two separate steps in this order, but can also be done in one step simultaneously. Preferably the overcoat layer is washed-off with water before the development step. The wash-off can be done with cold water, but it is preferred to use hot water to accelerate the process. What remains on the support after the development step are the exposed and thereby photopolymerized parts of the photosensitive layer. The developer solution used for the development of the exposed printing plate precursors of the present invention preferably is an aqueous alkaline solution having a pH of at least 11, a pH from 11.5 to 13.5 being particularly preferred. The developer solution can contain a small percentage, preferably less than 5 wt.%, of an organic, water-miscible solvent. To adjust the pH of the solution, an alkali hydroxide is preferably used.

Examples of preferred, additional ingredients of the developer solution comprise alone or in combination alkali phosphates, alkali carbonates, alkali bicarbonates, an organic amine compound, alkali silicates, buffering agents, complexants, defoamers, surface active agents and dyes, but the suitable ingredients are not limited to the preferred examples and further ingredients can be used.

The method of development employed is not particularly limited, and may be conducted by soaking and shaking the plate in a developer, physically removing non-image portions while being dissolved in a developer by means of e. g. a brush, or spraying a developer onto the plate so as to remove non-image portions. The time for development is selected depending upon the above method used so that the non-image portions can adequately by removed, and is optionally selected within a range of 5 seconds to 10 minutes.

After the development, the plate my be subjected to a hydrophilic treatment by means of, e. g., gum arabic optionally applied to the printing plate as the case requires (gumming step).

## Examples

### A. Violet sensitive printing plate precursor

A composition was prepared (pw = parts per weight; wt.% = weight percentage) by mixing the components as specified in table 1. A composition such as this was divided equally into portions of 24.61 g, and to each portion was added 1.608 g of a 33.0 wt.% solution in 2-butanone of the binder according to table 2. The resulting composition was coated on an electrochemically roughened and anodically oxidized aluminum sheet, the surface of which had been rendered hydrophilic by treatment with an aqueous solution of polyvinyl phosphonic acid (oxide weight 3 g/$m^2$) and was dried for 1 minute at 120 °C (circulation oven). The resulting thickness of the layer was 1.5 g/$m^2$.

**Table 1**

| Component | Parts per weight (g) |
|---|---|
| A solution containing 88.2 wt.% of a reaction product from 1 mole of 2,2,4-trimethyl-hexamethylenediisocyanate and 2 moles of hydroxyethylmethacrylate (viscosity 3.30 $mm^2$/s at 25°C) | 14.538 |
| Heliogene blue D 7490® dispersion (9.9 wt.%, viscosity 7.0 $mm^2$/s at 25 °C), trade name of BASF AG | 17.900 |
| 2,2'-bis(2-chlorophenyl)-4,4',5,5'-tetraphenyl-1,2-bisimidazole | 1.448 |
| 1,4-di[3,5-dimethoxy-4-(1-methylpropoxy)styryl]benzene (III-1) | 0.958 |
| Edaplan LA 411® (1 % in Dowanol PM®, trade mark of Dow Chemical Company) | 2.250 |
| MBT (mercaptobenzthiazole) | 0.068 |
| 2-butanone | 78.538 |
| propyleneglycol-monomethylether (Dowanol PM®, trade mark of Dow Chemical Company) | 130.358 |

**Table 2**

| Exp. | Type of Binder | Weight average Mw (GPC) | Ratio (meth)acrylate: (meth)acrylic acid (1H NMR) | Tg °C (measured by DSC) |
|---|---|---|---|---|
| 1 | Poly (methylmethacrylate -co-methacrylic acid) | 27386 | 82:18 | 127.8 |
| 2 | Poly(methylacrylate-co-acrylic acid) | 15205 | 87:13 | 24.0 |
| 3 | Poly(n-butylmethacrylate-co-acrylic acid) | 50928 | 81:19 | 32.1 |
| 4 | Poly(n-butylmethacrylate-co-methacrylic acid) | 65123 | 77:23 | 67.3 |
| 5 | Poly (benzylacrylate-co-acrylic acid) | 15571 | 89:11 | -7.5 |
| 6 | Poly(benzylacrylate-co-methacrylic acid) | 18412 | 86:14 | 12.9 |

On top of the photosensitive layer a solution in water with the composition as defined in table 3 was coated

and was dried at 110°C for 2 minutes.

**Table 3**

| Component | Parts by Weight (g) |
|---|---|
| partially hydrolyzed polyvinylalcohol (degree of hydrolysis 88 %, viscosity 4 mPa•s in a solution of 4 wt.% at 20 °C). | 17.03 |
| partially hydrolyzed polyvinylalcohol (degree of hydrolysis 88 %, viscosity 8 mPa•s in a solution of 4 wt.% at 20 °C). | 7.43 |
| fully hydrolyzed polyvinylalcohol (degree of hydrolysis 98 %, viscosity 6 mPa•s in a solution of 4 wt.% at 20 °C). | 14.87 |
| CA 24 E | 0.26 |
| Metolat FC 355 | 0.38 |
| Lutensol A8 (90%) | 0.032 |
| Water | 960 |

The so-formed protective overcoat had a dry thickness of 2.0 g/$m^2$.

The imaging was carried out with a Polaris violet platesetter device (flat bed system) equipped with a violet laser diode emitting between 392 and 417 nm. The following imaging conditions were used:

Scanning speed : 600 or 1000 m/sec
Variable image plane power : 0 to 25 mW
Spot diameter : 20 μm
Addressability : 1270 dpi

After imaging the plate was processed in an Agfa VSP85 processor at a speed of 1.2 m/min. Before the processing the plate was optionally heated by passing through the pre-heat section of the processor at 110°C (pre-heat step), next the protective overcoat was washed off and the photolayer was processed in a water based alkaline developer (Agfa PD91) at 28 °C. After a water rinsing and gumming step the printing plate was ready. A 13-step exposure wedge with density increments of 0.15 was used to determine sensitivity of the plate.

The results of the exposure tests are shown in table 4 as the sum of the density of the UGRA step wedges measured by a Gretag Macbeth D19C densitometer (cyan setting). One fully hardened step = 1.00. Higher values indicate higher sensitivity of the plate.

**Table 4.**

| Binder | Laser energy (μJ/$cm^2$) | UGRA sum. No Pre-heat | UGRA sum. With Pre-heat | |
|---|---|---|---|---|
| 1 | 86 | No image | 3.66 | Comparison |
| 1 | 192 | 0 | / | Comparison |
| 2 | 86 | 1.57 | 3.79 | Invention |
| 2 | 192 | 3.49 | / | Invention |
| 3 | 86 | 1.12 | 1.76 | Invention |
| 3 | 192 | 3.62 | / | Invention |
| 4 | 86 | 0.87 | 2.77 | Invention |
| 4 | 192 | 5.58 | / | Invention |
| 5 | 86 | 2.01 | 3.17 | Invention |
| 5 | 192 | 4.31 | / | Invention |
| 6 | 86 | 2.18 | 3.54 | Invention |
| 6 | 192 | 4.48 | / | Invention |

It can be clearly seen that binders with a Tg below 70°C give rise to the formation of a good image without the need for a pre-heat step. The image is even stronger when a higher laser energy is used.

**B. IR sensitive (thermal) printing plate precursor**

A composition was prepared (pw = parts per weight; wt.% = weight percentage) by mixing the components as specified in table 5. A composition such as this was divided into two portions of 78.84 g, and to each portion was added 8.61 g of a 33.0wt.% solution in methylethyl ketone of the binder according to table 2. The resulting composition was coated on an electrochemically roughened and anodically oxidized aluminum sheet, the surface of which has been rendered hydrophilic by treatment with an aqueous solution of polyvinyl phosphonic acid (oxide weight 3 g/m$^2$) and was dried for 1 minute at 120 °C (circulation oven). The resulting thickness of the layer was 1.5 g/m$^2$.

**Table 5**

| Component | Parts per weight (g) |
|---|---|
| a solution containing 88.2 wt.% of a reaction product from 1 mole of 2,2,4-trimethyl-hexamethylenediisocyanate and 2 moles of hydroxyethylmethacrylate (viscosity 3.30 mm$^2$/s at 25°C) | 7.44 |
| Heliogene blue D 7490® dispersion (9.9 wt.%, viscosity 7.0 mm$^2$/s at 25 °C), trade name of BASF AG | 15.35 |
| 2-[1,1'-biphenyl]-4-yl-4,6-bis(trichloromethyl)-1,3,5-triazine | 0.891 |
| Infrared Absorber IR-1 | 0.357 |
| Edaplan LA 411® (10 % in Dowanol PM®, trade mark of Dow Chemical Company) | 0.149 |
| 2-butanone | 43.50 |
| propyleneglycol-monomethylether (Dowanol PM®, trade mark of Dow Chemical Company) | 89.99 |

On top of the photosensitive layer a solution in water with the composition as defined in table 3 was coated and was dried at 110°C for 2 minutes.

The so-formed protective overcoat had a dry thickness of 2.0 g/m$^2$.

The imaging was carried out with a Creo X36 platesetter equipped with an IR laser diode emitting at 830 nm. The energy received by the plate was varied between 35 and 200 mJ/cm2 and the sensitivity of the plate was defined by the energy at which 53% solid density was obtained on a 50% screen.

After imaging the plate was processed in an Agfa VSP85 processor at a speed of 1.2 m/min. Before the processing the plate was optionally heated by passing through the pre-heat section of the processor at 110°C (pre-heat step), next the protective overcoat was washed off and the photolayer was processed in a water based alkaline developer (Agfa PD91) at 28 °C. After a water rinsing and gumming step the printing plate was ready.

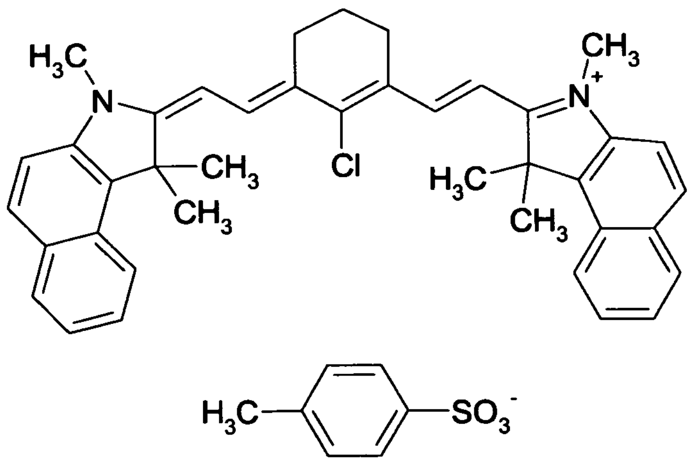

**IR-1**

The results are shown in Table 6 and the sensitivities were measured by the energy at which 53% solid density was achieved on a 50% screen.

**Table 6**

| Binder | Sensitivity ($mJ/cm^2$) No pre-heat | Sensitivity ($mJ/cm^2$) With pre-heat. | |
|---|---|---|---|
| 1 | No image | 46 | Comparison |
| 2 | 145 | 45 | Invention |

The results clearly show an improvement in sensitivity when the low Tg binder is used relative to the standard binder 1.

## Claims

1. A photopolymer printing plate precursor comprising a photosensitive coating on a support, wherein said photosensitive coating comprises a composition that is photopolymerizable upon absorption of light, said composition comprising at least one binder, a polymerizable compound, a sensitizer and a photoinitiator, **characterized in that** said binder is a copolymer that has a Tg of less than 70°C, and wherein 1 to 50 mol-% of the monomeric units of said copolymer contain at least one acidic group.

2. A photopolymer printing plate precursor according to claim 1, wherein the acidic group is selected from carboxylic acid group (-COOH), a carboxylic anhydride group (-(CO)O(CO)-), a sulfo group ($-SO_3H$), an imido group (HN=), a phosphono group ($-PO(OH)_2$), a N-acyl sulfonamido group ($-SO_2NH-COR$), or a phenolic hydroxy group (-phenyl-OH).

3. A photopolymer printing plate precursor according to claims 1 or 2, wherein the binder has a Tg of less than 50 °C.

4. A photopolymer printing plate precursor according to any of the preceding claims, comprising a protective layer on top of the photosensitive coating.

5. A photopolymer printing plate precursor according to claim 4, wherein the protective layer has a dry coating weight from more than 0.25 $g/m^2$ to less than 2.5 $g/m^2$.

6. A photopolymer printing plate precursor according to any of the preceding claims, wherein the binder is a copolymer containing monomeric units of an α, β-unsaturated carboxylic acid and/or an α,β-unsaturated dicarboxylic acid.

7. A photopolymer printing plate precursor according to any of the preceding claims further comprising a polyfunctional (meth)acrylate compound as a crosslinking agent.

8. A photopolymer printing plate precursor according to any of the preceding claims, wherein the polymerizable compound contains a urethane and/or urea group and/or a tertiary amino group.

9. A photopolymer printing plate precursor according to any of the preceding claims wherein the composition is photopolymerizable upon absorption of light having a wavelength between 300 and 600 nm.

10. A photopolymer printing plate precursor according to claim 9 wherein the photo-initiator is a hexaarylbisimidazole compound.

11. A photopolymer printing plate precursor according to claims 9 or 10 wherein the sensitizer is an optical brightening agent.

12. A photopolymer printing plate precursor according to claim 11 wherein the sensitizer has a structure according to one of the following formulae:

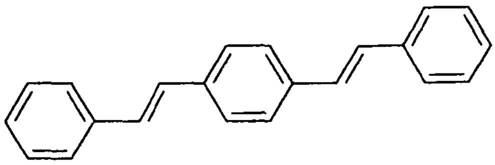

(III)

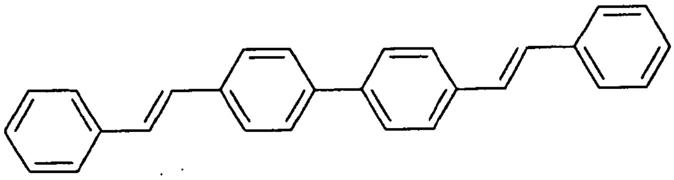

(IV)

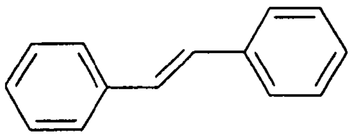

(V)

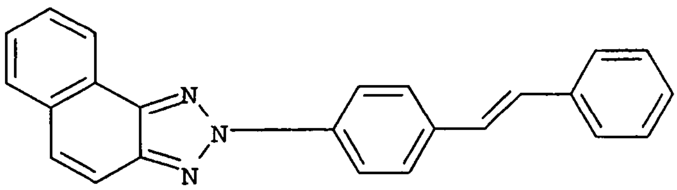

(VI)

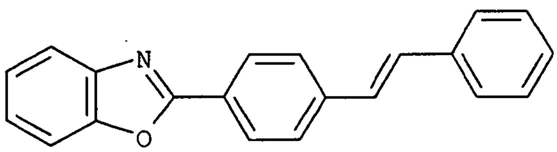

(VII)

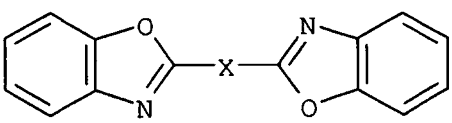

(VIII)

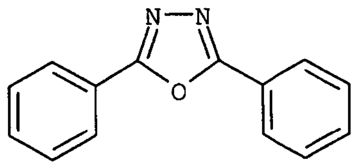

(IX)

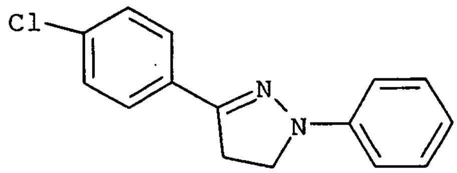

(X)

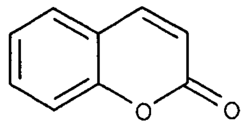

(XI)

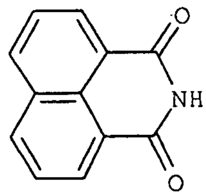

(XII)

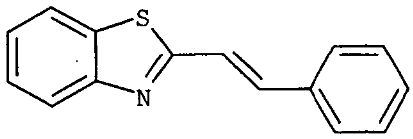

(XIII)

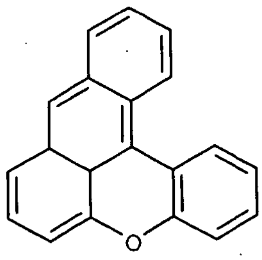

(XIV)

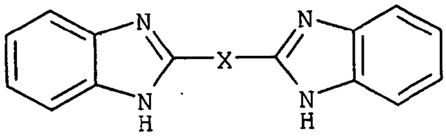

(XV)

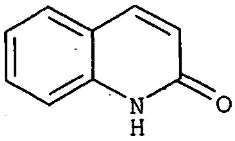

(XVI)

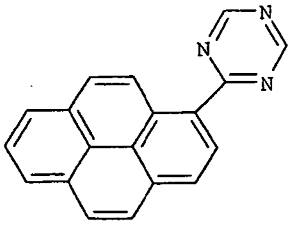

(XVII)

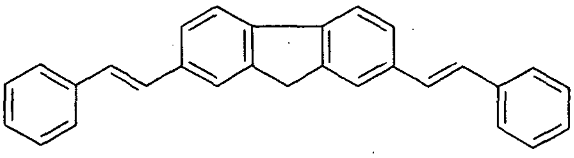

(XVIII)

wherein Z mutually independently means non-hydrogen, non-metallic atoms, wherein X is one of the following groups, * denoting the position of attachment in the above formulae:

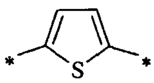

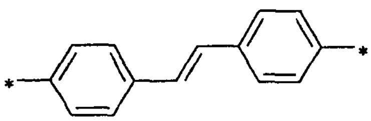

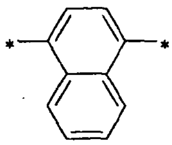

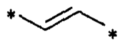

and wherein one or more of the nuclei in each of the above formulae (III) to (XIX) may be independently substituted by one or more groups selected from alkyl, alkoxy, alkylcarbonyl, alkoxycarbonyl, acyloxy, carboxyl, nitrile, amino, hydroxyl, alkylsulfonyl and aminosulfonyl.

**13.** A method of making a lithographic printing plate comprising the steps of providing a photopolymer printing plate precursor as defined in anyone of the claims 1 to 12, exposing said printing plate precursor with a laser and processing the printing plate precursor in an aqueous alkaline developer.

**14.** A method according to claim 13 wherein the exposure of the printing plate precursor is carried out at an energy density, measured on the surface of the plate, of 100 $\mu J/cm^2$ or less.

**15.** A method according to claim 13 or 14, wherein no pre-heat step is carried out.

**Patentansprüche**

**1.** Eine Fotopolymerdruckplattenvorstufe, die eine auf einen Träger angebrachte strahlungsempfindliche Beschichtung enthält, wobei die strahlungsempfindliche Beschichtung eine bei Absorption von Licht fotopolymerisierbare Zusammensetzung enthält, wobei die Zusammensetzung zumindest ein Bindemittel, eine polymerisierbare Verbindung, ein Sensibilisierungsmittel und einen Fotoinitiator enthält, **dadurch gekennzeichnet, dass** das Bindemittel ein Copolymer mit einem Tg von weniger als 70°C ist und 1 bis 50 mol-% der Monomereinheiten des Copolymers zumindest eine Säuregruppe enthält.

**2.** Fotopolymerdruckplattenvorstufe nach Anspruch 1, **dadurch gekennzeichnet, dass** als Säuregruppe eine Carbonsäuregruppe (-COOH), eine Carbonsäureanhydridgruppe (-(CO)O(CO)-), eine Sulfogruppe ($-SO_3H$), eine Imidgruppe (HN=), eine Phosphongruppe ($-PO(OH)_2$), eine N-Acylsulfonamidgruppe ($-SO_2NH-COR$) oder eine Phenolhydroxylgruppe (-Phenyl-OH) verwendet wird.

**3.** Fotopolymerdruckplattenvorstufe nach Anspruch 1 oder 2, **dadurch gekennzeichnet, dass** das Bindemittel einen Tg von weniger als 50°C aufweist.

**4.** Fotopolymerdruckplattenvorstufe nach einem der vorstehenden Ansprüche, die eine auf die strahlungsempfindliche Beschichtung angebrachte Schutzschicht umfasst.

**5.** Fotopolymerdruckplattenvorstufe nach Anspruch 4, **dadurch gekennzeichnet, dass** die Schutzschicht ein Trokkenschichtgewicht zwischen mehr als 0,25 $g/m^2$ und weniger als 2,5 $g/m^2$ aufweist.

**6.** Fotopolymerdruckplattenvorstufe nach einem der vorstehenden Ansprüche, **dadurch gekennzeichnet, dass** das Bindemittel ein Copolymer mit Monomereinheiten einer $\alpha,\beta$-ungesättigten Carbonsäure und/oder einer $\alpha,\beta$-ungesättigten Dicarbonsäure ist.

**7.** Fotopolymerdruckplattenvorstufe nach einem der vorstehenden Ansprüche, die ferner eine polyfunktionnelle (Meth) acrylatverbindung als Vernetzungsmittel enthält.

**8.** Fotopolymerdruckplattenvorstufe nach einem der vorstehenden Ansprüche, **dadurch gekennzeichnet, dass** die polymerisierbare Verbindung eine Urethangruppe und/oder eine Harnstoffgruppe und/oder eine tertiäre Aminogruppe enthält.

**9.** Fotopolymerdruckplattenvorstufe nach einem der vorstehenden Ansprüche, **dadurch gekennzeichnet, dass** die Zusammensetzung bei Absorption von Licht im Wellenlängenbereich zwischen 300 nm und 600 nm fotopolymerisierbar ist.

**10.** Fotopolymerdruckplattenvorstufe nach Anspruch 9, **dadurch gekennzeichnet, dass** der Fotoinitiator eine Hexaarylbisimidazol-Verbindung ist.

**11.** Fotopolymerdruckplattenvorstufe nach Anspruch 9 oder 10, **dadurch gekennzeichnet, dass** das Sensibilisierungsmittel ein optisches Aufhellmittel ist.

**12.** Fotopolymerdruckplattenvorstufe nach Anspruch 11, **dadurch gekennzeichnet, dass** das Sensibilisierungsmittel eine Struktur gemäß einer der folgenden Formeln hat :

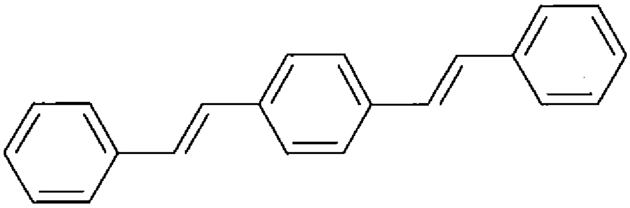

(III)

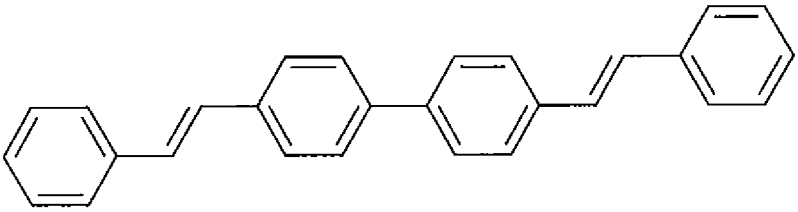

(IV)

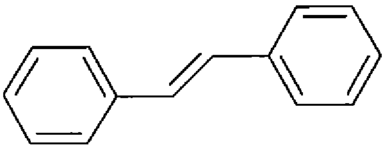

(V)

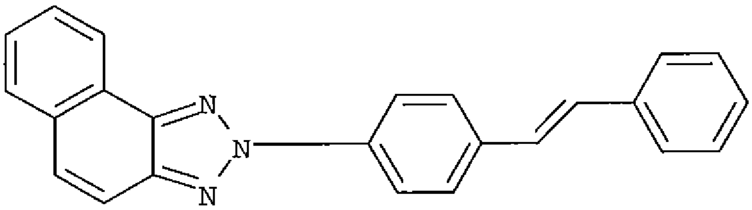

(VI)

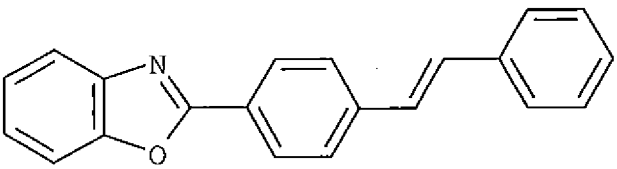

(VII)

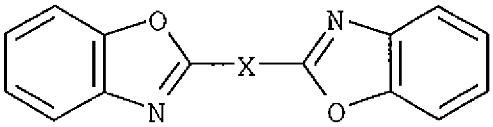

(VIII)

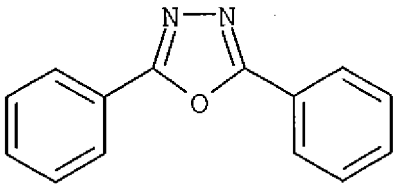

(IX)

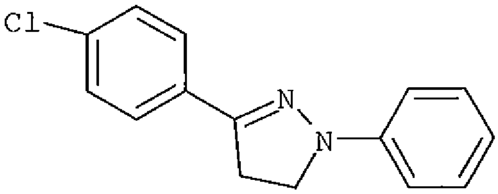

(X)

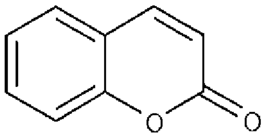

(XI)

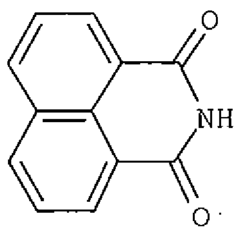

(XII)

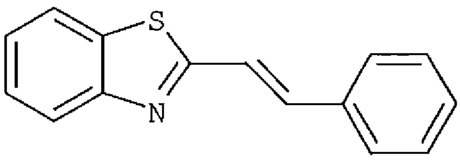

(XIII)

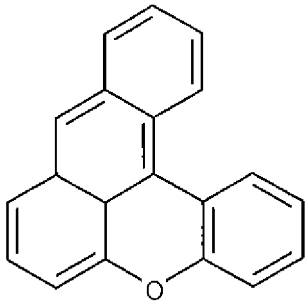

(XIV)

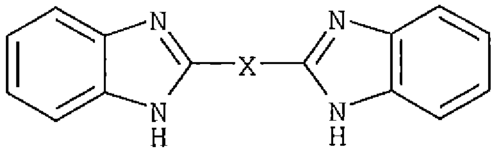

(XV)

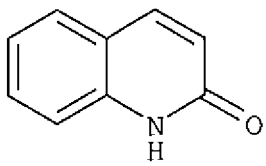

(XVI)

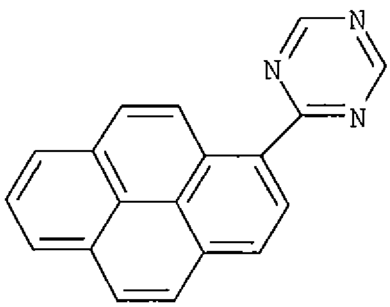

(XVII)

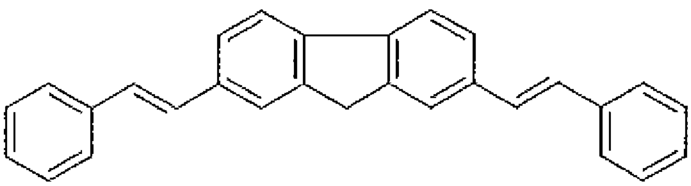

(XVIII)

in denen Z unabhängig voneinander jeweils ein beliebiges Atom außer einem Wasserstoffatom und Metallatomen bedeutet, wobei X eine der folgenden Gruppen ist, wobei * die Bindungsstelle in den obigen Formeln angibt :

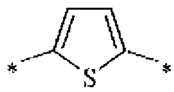

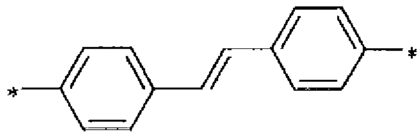

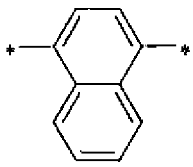

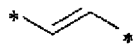

und wobei einer oder mehrere der Ringe in jeder der obigen Formeln (III) bis (XVIII) unabhängig voneinander durch eine oder mehrere Gruppen aus der Reihe bestehend aus einer Alkylgruppe, einer Alkoxygruppe, einer Alkylcarbonylgruppe, einer Alkoxycarbonylgruppe, einer Acyloxygruppe, einer Carboxylgruppe, einer Nitrilgruppe, einer Aminogruppe, einer Hydroxylgruppe, einer Alkylsulfonylgruppe und einer Aminosulfonylgruppe substituiert sein kann (können).

**13.** Ein Verfahren zur Herstellung einer lithografischen Druckplatte, das folgende Schritte umfasst : das Bereitstellen einer wie in einem der Ansprüche 1 bis 12 definierten Fotopolymerdruckplattenvorstufe, die Laserbelichtung der Druckplattenvorstufe und die Entwicklung der Druckplattenvorstufe in einem wässrig-alkalischen Entwickler.

**14.** Verfahren nach Anspruch 13, **dadurch gekennzeichnet, dass** die Belichtung der Druckplattenvorstufe bei einer auf der Plattenoberfläche gemessenen Energiedichte von höchstens 100 $\mu J/cm^2$ erfolgt.

**15.** Verfahren nach Anspruch 13 oder 14, **dadurch gekennzeichnet, dass** kein Vorwärmschritt durchgeführt wird.

**Revendications**

**1.** Un précurseur de plaque d’impression photopolymère, comprenant un revêtement photosensible appliqué sur un support, ledit revêtement photosensible contenant une composition photopolymérisable par absorption de lumière, ladite composition contenant au moins un liant, un composé polymérisable, un sensibilisateur et un photoinitiateur, **caractérisé en ce que** le liant est un copolymère présentant une valeur Tg inférieure à 70°C et que 1 à 50 moles % des unités monomères du copolymère contient au moins un groupe acide.

**2.** Précurseur de plaque d’impression photopolymère selon la revendication 1, **caractérisé en ce que** le groupe acide est choisi parmi le groupe composé d’un groupe acide carboxylique (-COOH), d’un groupe anhydride carboxylique (-(CD)O(CO)-), d’un groupe sulfo ($-SO_3H$), d’un groupe imido (HN=), d’un groupe phosphono ($-PO(OH)_2$), d’un groupe N-acylsulfonamido ($-SO_2NH-COR$) et d’un groupe hydroxyle phénolique (-phényl-OH).

**3.** Précurseur de plaque d’impression photopolymère selon la revendication 1 ou 2, **caractérisé en ce que** le liant présente une valeur Tg inférieure à 50°C.

4. Précurseur de plaque d'impression photopolymère selon l'une quelconque des revendications précédentes, comprenant une couche protectrice appliquée sur le revêtement photosensible.

5. Précurseur de plaque d'impression photopolymère selon la revendication 4, **caractérisé en ce que** la couche protectrice est appliquée dans une épaisseur de couche sèche comprise entre plus de 0,25 $g/m^2$ et moins de 2,5 $g/m^2$.

6. Précurseur de plaque d'impression photopolymère selon l'une quelconque des revendications précédentes, **caractérisé en ce que** le liant est un copolymère contenant des unités monomères d'un acide carboxylique α,β-insaturé et/ou des unités monomères d'un acide dicarboxylique α,β-insaturé.

7. Précurseur de plaque d'impression photopolymère selon l'une quelconque des revendications précédentes, contenant en outre un composé de (méth)acrylate polyfonctionnel comme réticulant.

8. Précurseur de plaque d'impression photopolymère selon l'une quelconque des revendications précédentes, **caractérisé en ce que** le composé polymérisable contient un groupe uréthane et/ou un groupe urée et/ou un groupe amino tertiaire.

9. Précurseur de plaque d'impression photopolymère selon l'une quelconque des revendications précédentes, **caractérisé en ce que** la composition est photopolymérisable par absorption de lumière présentant une longueur d'onde comprise dans la plage de 300 nm à 600 nm.

10. Précurseur de plaque d'impression photopolymère selon la revendication 9, **caractérisé en ce que** le photoinitiateur est un composé d'hexaarylbisimidazole.

11. Précurseur de plaque d'impression photopolymère selon la revendication 9 ou 10, **caractérisé en ce que** le sensibilisateur est un agent de blanchiment optique.

12. Précurseur de plaque d'impression photopolymère selon la revendication 11, **caractérisé en ce que** le sensibilisateur présente une structure répondant à l'une des formules ci-après :

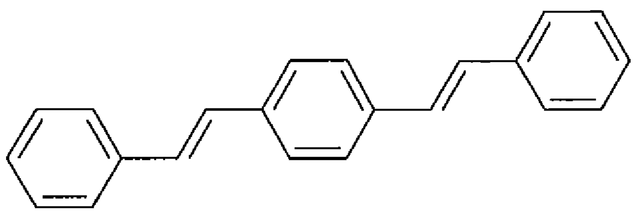

(III)

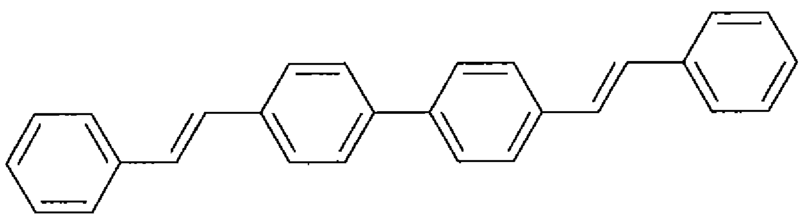

(IV)

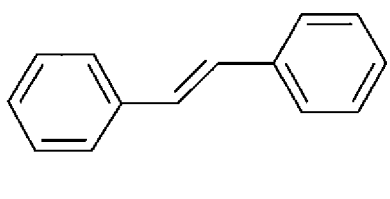

(V)

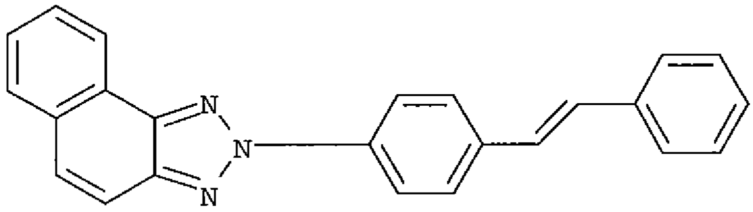

(VI)

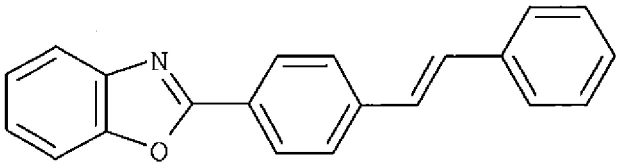

(VII)

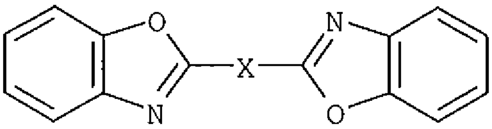

(VIII)

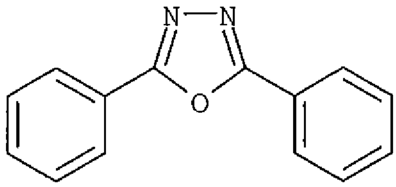

(IX)

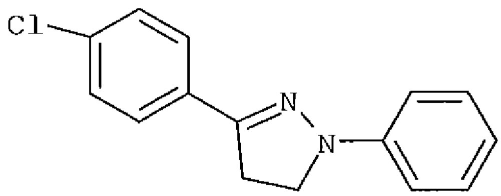

(X)

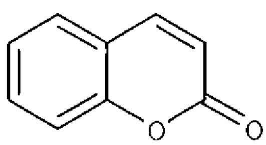

(XI)

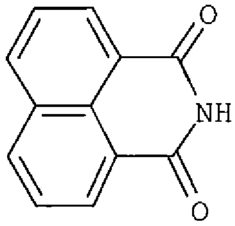

(XII)

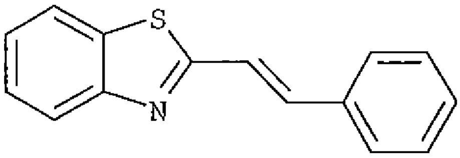

(XIII)

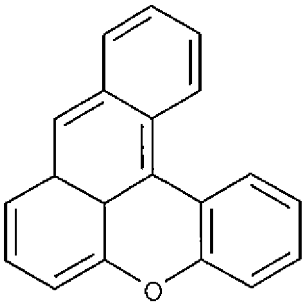

(XIV)

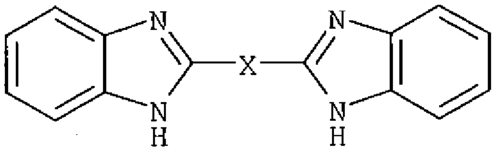

(XV)

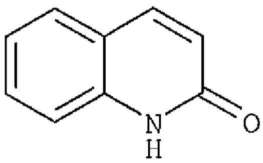

(XVI)

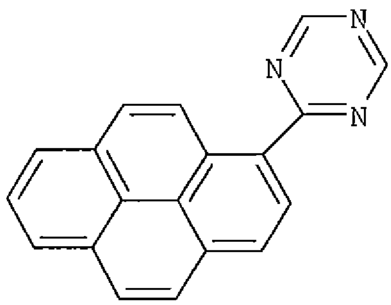

(XVII)

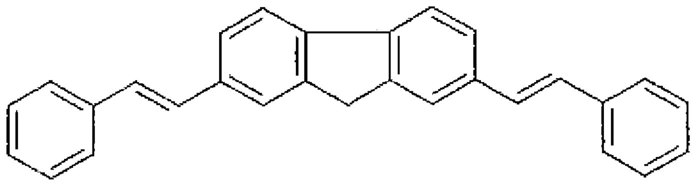

(XVIII)

où Z représente indépendamment un atome quelconque, hormis un atome d'hydrogène et un atome métallique, où X représente un des groupes ci-après, où * représente la position de liaison dans les formules reprises ci-dessus :

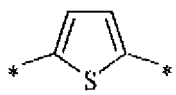

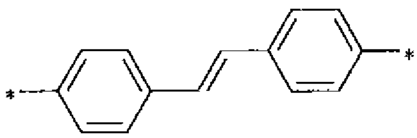

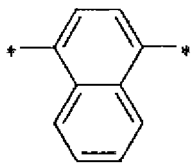

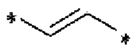

et où un ou plusieurs des noyaux dans chacune des formules (III) à (XVIII) reprises ci-dessus peuvent être substitués, indépendamment l'un de l'autre, par un ou plusieurs groupes choisis parmi le groupe composé d'un groupe alkyle, d'un groupe alkoxy, d'un groupe alkylcarbonyle, d'un groupe alkoxycarbonyle, d'un groupe acyloxy, d'un groupe carboxyle, d'un groupe nitrile, d'un groupe amino, d'un groupe hydroxyle, d'un groupe alkylsulfonyle et d'un groupe aminosulfonyle.

**13.** Un procédé pour la confection d'une plaque d'impression lithographique, comprenant les étapes ci-après : la mise

à disposition d'un précurseur de plaque d'impression photopolymère tel que défini selon l'une quelconque des revendications 1 à 12, l'exposition laser du précurseur de plaque d'impression et le développement du précurseur de plaque d'impression dans un révélateur alcalin aqueux.

**14.** Procédé selon la revendication 13, **caractérisé en ce que** l'exposition du précurseur de plaque d'impression est effectuée à une densité d'énergie maximale, mesurée sur la surface de la plaque, de 100 $\mu J/cm^2$

**15.** Procédé selon la revendication 13 ou 14, **caractérisé en ce que** le procédé ne comprend pas d'étape de préchauffage.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- DE 2064080
- EP 398325 A
- US 4780393 A
- US 4940647 A
- GB 1576217 A
- EP 718695 A
- US 5348844 A
- US 5212049 A
- EP 480335 A
- US 4248960 A
- US 6326126 B
- US 6017678 A
- US 6780566 B
- EP 1403043 A
- EP 1403042 A
- EP 1403041 A
- EP 1176467 A
- EP 1349006 A
- EP 1148387 A1
- EP 1280006 A2
- EP 1035435 A2
- EP 1048982 A1
- EP 985683 A1
- EP 1070990 A1
- EP 1091247 A2
- DE 1470154
- EP 24629 A
- EP 107792 A
- US 4410621 A
- EP 215453 A
- DE 3211312
- EP 1091247 A
- EP 287818 A
- EP 316706 A
- EP 355387 A
- DE 2822190
- DE 2064079
- DE 19915717
- DE 19933139
- EP 352630 B1


### Non-patent literature cited in the description


- Ullmann's Encyclopedia of Industrial Chemistry. Wiley-VCH, 1998
- **B.P. LUGOVKIN ; B.A. ARBUZOV.** *Doklady Akademii Nauk SSSR,* 1948, vol. 59, 1301-1304